(19) Europäisches Patentamt / European Patent Office / Office européen des brevets

(11) **EP 2 436 035 B1**

(12) **FASCICULE DE BREVET EUROPEEN**

(45) Date de publication et mention de la délivrance du brevet:
**06.05.2020 Bulletin 2020/19**

(21) Numéro de dépôt: **10724050.9**

(22) Date de dépôt: **27.05.2010**

(51) Int Cl.:
*H01L 27/22* (2006.01)   *G11C 11/16* (2006.01)
*H01F 10/32* (2006.01)   *H01L 43/08* (2006.01)
*H01L 43/10* (2006.01)   *G01R 33/09* (2006.01)
*G01R 33/12* (2006.01)   *B82Y 25/00* (2011.01)

(86) Numéro de dépôt international:
**PCT/EP2010/057326**

(87) Numéro de publication internationale:
**WO 2010/136527 (02.12.2010 Gazette 2010/48)**

(54) **DISPOSITIF DE MEMOIRE MAGNETIQUE A POLARISATION DE SPIN ET SON PROCEDE D'UTILISATION**

MAGNETISCHE SPEICHERVORRICHTUNG, WELCHE EINE SPIN-POLARISIERUNG BENUTZT, UND VERFAHREN ZUM BETREIBEN DERSELBEN

MAGNETIC MEMORY DEVICE USING SPIN POLARISATION AND METHOD OF USING THE SAME

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **27.05.2009 FR 0953512**

(43) Date de publication de la demande:
**04.04.2012 Bulletin 2012/14**

(73) Titulaires:
• **Commissariat à l'Énergie Atomique et aux Énergies Alternatives**
**75015 Paris (FR)**
• **Institut Polytechnique de Grenoble**
**38031 Grenoble Cedex (FR)**
• **Centre National de la Recherche Scientifique (C.N.R.S.)**
**75794 Paris Cedex 16 (FR)**

(72) Inventeurs:
• **DIENY, Bernard**
**F-38250 Lans en Vercors (FR)**
• **PAPUSOI, Cristian**
**F-38000 Grenoble (FR)**
• **EBELS, Ursula**
**F-38100 Grenoble (FR)**
• **HOUSSAMEDDINE, Dimitri**
**F-38000 Grenoble (FR)**
• **BUDA-PREJBEANU, Liliana**
**F-38360 Sassenage (FR)**
• **SOUSA, Ricardo**
**F-38000 Grenoble (FR)**

(74) Mandataire: **Lebkiri, Alexandre**
**Cabinet Camus Lebkiri**
**25, Rue de Maubeuge**
**75009 Paris (FR)**

(56) Documents cités:
**US-A1- 2009 015 958**

**Description**

La présente invention concerne un dispositif magnétique à polarisation de spin. Elle trouve une application en électronique, notamment dans la réalisation de points mémoire et de mémoire de type MRAM (« Magnectic Random Access Memory ») ou mémoire magnétique à accès aléatoire.

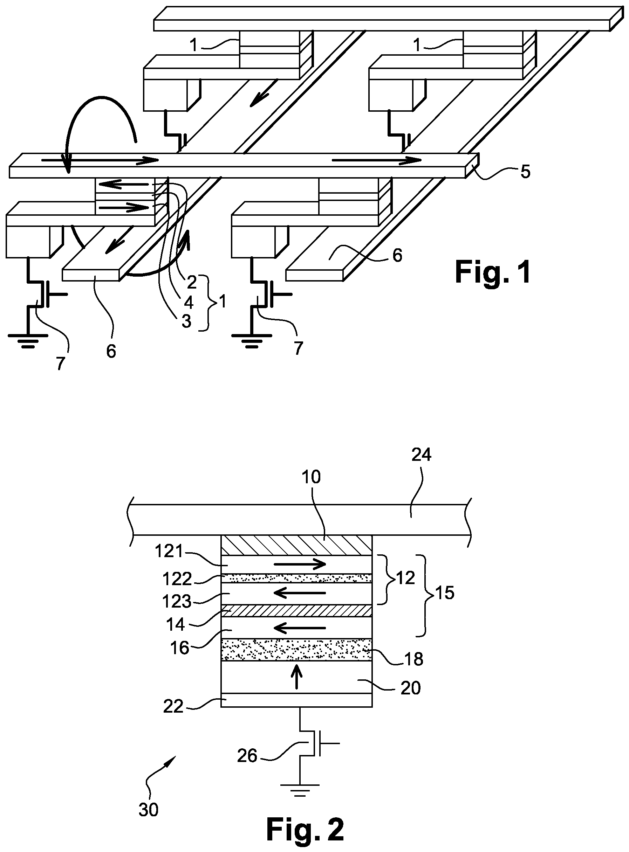

Le contexte est celui des MRAMs à base de jonctions tunnels magnétiques (dits également empilements magnétorésistifs) et plus particulièrement des MRAMs dans lesquelles l'écriture est réalisée par transfert de spin. La figure 1 illustre schématiquement la structure et la fonction d'une telle jonction portant la référence 1. De façon connue, la jonction tunnel magnétique (ou empilement magnétorésistif) 1 est composée de deux couches magnétiques 2 et 3 séparées par une couche d'oxyde 4 formant une barrière tunnel, typiquement en oxyde d'aluminium ou de magnésium. L'aimantation de l'une des couches magnétiques 2, dite couche de stockage (couche d'aimantation ré-orientable suivant deux directions sensiblement opposées) peut être orientée dans différentes directions par rapport à l'aimantation de la seconde couche 3, dite couche de référence, dont l'aimantation est piégée dans une direction fixe. Ce piégeage est en général réalisé par interaction avec une couche antiferromagnétique adjacente non représentée (mécanisme d'anisotropie d'échange). Différents niveaux de résistance de la jonction tunnel peuvent être réalisés en fonction de l'angle entre les aimantations des deux couches de stockage et de référence. Ainsi l'information est stockée dans l'élément magnétique par la configuration magnétique parallèle ou antiparallèle des aimantations des couches de stockage 2 et de référence 3. Ensuite la variation de résistance en fonction de la configuration magnétique est utilisée pour relire l'information écrite dans la cellule mémoire. Lorsque les aimantations des couches magnétiques 2 et 3 sont antiparallèles, la résistance de la jonction 1 est élevée ; lorsque les aimantations sont parallèles, la résistance devient faible. La variation de résistance entre ces deux états peut dépasser 100% par un choix approprié des matériaux. Chaque jonction tunnel 1 constitue un point mémoire.

Dans l'approche la plus classique des MRAMs avec écriture par champs magnétiques perpendiculaires, les jonctions tunnels 1 sont disposées en un réseau carré inséré entre deux réseaux perpendiculaires de lignes parallèles : les lignes de bits 5 (ou « bit lines » en anglais) et les lignes de mots 6 (ou « word lines » en anglais), l'une au dessus, l'autre en dessous du plan des jonctions tunnels 1. Les jonctions 1 sont placées entre un transistor 7 et une ligne de bits 5. Un courant passant dans cette ligne de bits 5 produit un champ magnétique. Un courant passant dans la ligne de mots 6 orthogonale à la ligne de bits 5 permet de produire un second champ magnétique. Au moment de l'écriture, le transistor 7 est bloqué et des impulsions de courant sont envoyées simultanément dans la ligne de mots 6 et la ligne de bits 5 qui se croisent au niveau du point mémoire 1 adressé. La combinaison de ces deux champs permet de faire commuter l'aimantation de la couche de stockage du point mémoire 1 adressé dans la direction souhaitée sans affecter l'aimantation des autres points mémoires. Dans le mode « lecture », le transistor 7 est en régime saturé. Le courant envoyé dans la ligne de bits 5 traverse uniquement le point mémoire dont le transistor est ouvert. Ce courant permet de mesurer la résistance de la jonction. Par comparaison avec un point mémoire de référence, l'état binaire du point mémoire (« 0 » ou « 1 ») peut ainsi être déterminé.

Le mécanisme d'écriture décrit ci-dessus présente cependant certaines difficultés.

Le premier problème est un problème de sélectivité. Comme le renversement de l'aimantation de la couche de stockage d'une jonction se produit sous l'effet de champs extérieurs et comme les champs de retournement sont statistiquement distribués, il n'est pas impossible de retourner accidentellement certaines jonctions voisines simplement par l'effet du champ magnétique produit le long de la ligne d'adressage. Comme, pour des mémoires à haute densité, la taille des points mémoires est nettement submicronique, le nombre d'erreurs d'adressage augmente. Ce problème de sélectivité a pu être amélioré par l'introduction d'une technologie d'écriture dite « toggle » décrite dans le brevet US6545906 mais au prix d'une consommation électrique accrue.

Par ailleurs, les courants nécessaires dans les lignes de bits et les lignes de mots pour créer les champs magnétiques nécessaires à l'écriture sont de plusieurs mA (typiquement 5 à 7mA). Lorsqu'on cherche à augmenter la densité des mémoires ou des circuits logiques, la section de ces lignes conductrices doit diminuer alors que le courant nécessaire à la génération des impulsions de champ magnétique reste du même ordre de grandeur voire même augmente. On se heurte alors rapidement à la limite d'électromigration dans ces lignes, atteinte pour des densités de courant typiquement de l'ordre de $10^7 A/cm^2$. Pour un courant de 4mA, cette limite d'électromigration est par exemple atteinte pour des conducteurs de section sensiblement égale à 200nm*200nm.

Plus récemment sont apparus d'autres types de dispositifs magnétiques permettant de palier le problème évoqué ci-dessus. Dans de tels dispositifs, le renversement de l'aimantation se produit non plus par des champs magnétiques extérieurs mais en utilisant l'action exercée par un courant polarisé en spin qui entre dans la couche de stockage de la jonction tunnel. En effet, il avait été prédit théoriquement par JC.Slonczewski et L.Berger (Journ.magn.Magn.Mater.159, L1 (1996) et Phys.Rev.B.54, 9353 (1996)) et observé expérimentalement quelques années plus tard par J.Katine et al (Phys.Rev.Lett.84, 3149 (2000)), que lorsqu'un courant polarisé en spin est injecté dans une nanostructure magnétique, ce courant exerce un couple sur l'aimantation de la nanostructure, appelé couple de transfert de spin (« spin transfer torque » ou « spin-torque » en anglais), qui peut permettre d'agir sur l'aimantation de la nanostructure et en particulier de la réorienter dans une direction souhaitée. Ce phénomène de commutation magnétique par transfert de spin a tout d'abord été observé dans des systèmes entièrement métalliques formés par exemple d'une alternance de couches de Co et Cu du type Co 20nm/Cu 4nm/Co 3nm (Phys.Rev.Lett.84, 3149 (2000)). Quelques années plus tard, ce même phénomène de commutation magnétique par transfert de spin a été observé dans les jonctions tunnels magnétiques de faible résistance (Appl.Phys.Lett.84, 3118 (2004)). Ce phénomène de transfert de spin peut donc être utilisé comme un nouveau moyen d'écriture de l'information dans des dispositifs du type MRAMs ou composants logiques. JC.Slonczewski a montré que ce couple de transfert de spin à la forme d'un nouveau terme dans l'équation de Landau Lifshitz Gilbert qui régit la dynamique d'aimantation dans les systèmes magnétiques. Ce nouveau terme de couple T exercé par le courant de spin sur l'aimantation locale s'écrit $T = a_J$ Mx(MxP) dans lequel le pré-facteur $a_J$ (dit par la suite coefficient de transfert de spin) est proportionnel à la densité de courant traversant la nanostructure et à la polarisation de ce courant, M est le vecteur représentant l'aimantation de la nanostructure traversée par le courant polarisée en spin, P est la direction de polarisation du courant et le signe « x » désigne le produit vectoriel. Comme le pré-facteur du terme de transfert de spin est proportionnel à la densité de courant traversant la nanostructure, la densité de courant détermine le seuil de commutation de l'aimantation de la nanostructure magnétique et non le courant total comme dans les approches d'écriture par champ magnétique. Par exemple, pour une nanostructure magnétique d'aimantation planaire, d'épaisseur d, de dimension suffisamment petite (typiquement inférieure à 100nm) pour pouvoir être traitée en approximation macrospin, il a été montré que l'aimantation de la nanostructure peut commuter sous l'influence d'un courant polarisé en spin traversant cette nanostructure perpendiculairement à son plan, lorsque le pré-facteur du terme de transfert de spin atteint la valeur $(a_J)_{crit} = \pm \alpha(2\pi M_s + H_K) + \alpha H_{ext}$ $\approx \alpha 2\pi M_s$, où $\alpha$ est la constante d'amortissement de Gilbert, $M_s$ est l'aimantation spontanée de la nanostructure, $H_K$ est le champ d'anisotropie. Cette valeur critique du pré-facteur $a_J$ détermine la valeur critique de la densité de ce courant provoquant la commutation magnétique sachant que les deux grandeurs sont reliées par :

$$(a_J) = -\frac{|g|}{2}\frac{\mu_B}{M_s^2}\frac{1}{d}\frac{J}{e}P$$ où g (environ égal à 2) est le facteur de Landé, $\mu_B$ le magnéton de Bohr, e la charge de l'électron, P la polarisation du courant et J la densité de courant (Sun, Phys.Rev.B. 62, 570 (2000)). On notera que l'expression du nouveau terme de couple $T = a_J$ $M \times (M \times P)$ exercé par le courant de spin sur l'aimantation locale vaut plus particulièrement pour les configurations à vannes de spin. Dans le cas d'une configuration à jonction tunnel magnétique, le nouveau terme de couple **T** exercé par le courant de spin sur l'aimantation locale peut s'écrire $T = a_J$ $M \times (M \times P) + b_J$ $M \times P$. On retrouve le premier terme $a_J$ $M \times (M \times P)$ auquel vient s'ajouter un second terme $b_J$ $M \times P$ dans lequel le pré-facteur $b_J$ représente le coefficient du champ effectif induit par courant. Contrairement au cas d'une vanne de spin, dans une jonction tunnel magnétique, le terme de champ effectif n'est pas négligeable.

De ce fait, lorsque la dimension latérale de l'élément mémoire ou composant logique est réduite, le courant nécessaire diminue aussi en fonction de la section de l'élément, le courant étant égal au produit de la densité de courant par la section de l'élément. Ainsi, cette approche d'écriture par transfert de spin offre de bien meilleures perspectives d'évolution des caractéristiques des dispositifs mémoires ou logiques mettant en œuvre ces éléments que pour une écriture impliquant des impulsions de champs magnétiques générés par des impulsions de courant électriques dans des lignes conductrices.

Lorsqu'on cherche à utiliser le transfert de spin comme moyen d'écriture dans les MRAMs à base de jonctions tunnels magnétiques, un point très important est la densité de courant à laquelle se produit la commutation. Cette densité de courant doit être suffisamment faible pour deux raisons.

La première raison concerne la possibilité pour cette densité de courant de traverser la barrière tunnel sans l'endommager électriquement. En effet lorsqu'une densité de courant j traverse une barrière tunnel présentant un produit RA de sa résistance R par son aire A, il apparait une tension V=RA*j entre les deux électrodes de la jonction. Or la tension est limitée par le claquage électrique (typiquement à des valeurs de 0.7V à 1.5V suivant l'épaisseur de la barrière tunnel) et la magnétorésistance tend à décroître fortement pour des produits RA inférieurs à $10\Omega.\text{gm}^2$. Ceci implique que la densité de courant maximale de commutation que l'on souhaite pour ne pas générer de stress électrique excessif de la barrière tunnel avec une magnétorésistance importante doit être de l'ordre de $10^6$ A/cm$^2$ voire $6.10^5$A/cm$^2$.

La deuxième raison est que la taille du transistor de sélection connecté en série avec la jonction tunnel dépend directement du courant total devant traverser le transistor. Ce courant est typiquement de $700\mu$A par micron de largeur du canal de transistor. Pour que la minimisation de la taille de la cellule MRAM ne soit pas limitée par la taille du transistor, il faut que cette taille du transistor soit du même ordre de grandeur que la taille de la jonction. En supposant que la largeur L du transistor soit égale au diamètre de la jonction tunnel, on aboutit à une densité $J_{écriture}$ de courant d'écriture qui doit être tel que le produit $J_{écriture}L^2$ soit environ égal à 0.7mA/$\mu$m*L ; en d'autres termes, $J_{écriture}$ doit être environ égal à

0.7mA/μm/L. Pour une taille L de jonctions de l'ordre de 50nm, on obtient une densité Jécriture environ égale à $7.10^5$A/cm$^2$. On retrouve donc le même ordre de grandeur souhaité pour la densité de courant de commutation que celle obtenu pour la première raison mentionné dans le paragraphe précédent.

Or selon l'état de l'art actuel, avec des jonctions tunnels à base de MgO et à aimantation planaire, les densités de courant critiques observées sont de l'ordre de $7.10^6$A/cm$^2$ pour une commutation en quelques nanosecondes (cf. article de Y.Huai et al, Appl.Phys.Lett.87, 222510 (2005)). Cette densité de courant est encore trop grande par rapport à la valeur que l'on cherche à atteindre inférieure à $10^6$A/cm$^2$.

Une première solution connue pour abaisser le courant critique est décrite dans la demande de brevet FR2832542. Cette solution consiste à adjoindre à la jonction tunnel du côté de la couche douce opposé à la barrière tunnel, une deuxième couche piégée d'aimantation opposée à celle de la première couche piégée de la jonction tunnel et séparée de la couche douce par un espaceur métallique d'épaisseur typiquement de l'ordre de 3 à 5nm (configuration dite « duale »). Cette épaisseur doit être suffisamment importante pour permettre le découplage magnétique entre la deuxième couche piégée et la couche douce (typiquement au-delà de 2nm). Mais elle doit être suffisamment faible par rapport à la longueur de diffusion de spin pour que les électrons gardent la mémoire de leur spin dans leur passage de la deuxième couche piégée à la couche douce. Dans cet empilement, comme la résistance de la barrière tunnel est la contribution dominante de la résistance électrique de l'empilement, toute la magnétorésistance de la structure provient de la jonction tunnel formée par première couche piégée/barrière tunnel/couche douce. Par contre, du point de vue du transfert de spin, il y a un effet cumulatif des deux couples de transfert de spin exercés par l'une et l'autre des deux couches piégées. Ceci est mentionné dans le brevet FR2832542 et a été démontré plus tard théoriquement par L.Berger dans l'article Journ.Appl.Phys.93(2003)7693 et vérifié expérimentalement dans l'article de Y.Huai et al, Appl.Phys.Lett.87, 222510 (2005). Ainsi dans ce dernier article, il a été montré que l'adjonction d'une deuxième couche piégée d'aimantation opposée à celle de la première couche piégée de la jonction tunnel permettait d'abaisser le courant critique de commutation de densité de l'ordre de $7.10^6$A/cm$^2$ à 2.2 $10^6$A/cm$^2$. Le courant critique a été abaissé d'un facteur 3 par cette configuration duale mais cette valeur reste encore trop grande. Par ailleurs, cette configuration ne résout pas le problème des fluctuations stochastiques du temps de retournement ou de commutation.

En effet, de façon connue, la direction de piégeage de la couche de référence ou couche piégée est parallèle ou antiparallèle à l'aimantation de la couche de stockage. C'est en effet cette configuration qui maximise l'amplitude de magnétorésistance. Toutefois, une telle configuration implique que la polarisation du courant qui exerce le transfert de spin sur l'aimantation de la couche douce soit initialement parallèle ou antiparallèle à l'aimantation de cette dernière. Or comme le couple de transfert de spin varie comme le sinus de l'angle entre la polarisation du courant et l'aimantation, le couple est initialement nul de sorte que la commutation a du mal à se déclencher. Il faut alors attendre que sous l'effet d'une fluctuation thermique aléatoire, un petit angle apparaisse entre l'aimantation de la couche douce et la direction de polarisation du courant, pour que le couple de transfert de spin augmente et déclenche le retournement d'aimantation. Il s'en suit qu'il existe un temps d'attente entre le début du pulse de courant et le retournement d'aimantation qui peut varier de quelques 100ps à quelques 10ns. Ceci a été montré expérimentalement dans la publication de T.Devolder et al (Phys.Rev.Lett.100, 057206 (2008)). Dans un fonctionnement de mémoires ou de composants logiques, il est clair que ce temps d'attente est particulièrement gênant car il limite la vitesse de fonctionnement de la mémoire ou du composant.

Une deuxième solution pour réduire la densité de courant critique de commutation est également décrite dans la demande de brevet FR2832542. Cette solution consiste à utiliser des matériaux à aimantation perpendiculaire au plan des couches. En effet lorsqu'on injecte un courant de polarisation planaire dans une nanostructure d'aimantation planaire, la densité de courant critique est exprimée par

$$J_{WR\,in-plane} = \left(\frac{2e}{\hbar}\right)\frac{\alpha\, t_F}{P}\left(\frac{\mu_0 M_S^{\,2}}{2} + 2K\right) \quad \text{où} \quad e$$

est la charge de l'électron, $\hbar$ la constante de Planck, $t_F$ l'épaisseur de la nanostructure, $\alpha$ l'amortissement de Gilbert, P la polarisation du courant, J la densité de courant, $\mu_0$ la perméabilité du vide, $M_S$ l'aimantation de la nanostructure et K son anisotropie (Sun, Phys.Rev.B. 62, 570 (2000)). Dans cette expression, le terme $\dfrac{\mu_0 M_S^{\,2}}{2}$ représente l'énergie de champ démagnétisant qui est en général beaucoup plus grande (typiquement par 1 à 2 ordres de grandeur) que l'énergie d'anisotropie de la nanostructure. Ce terme est associé au fait que lors du retournement de l'aimantation, cette dernière doit précesser en sortant hors du plan, ce qui lui coûte cette énergie de champ démagnétisant. Ceci conduit aux densités de courant précédemment mentionnées de l'ordre de $7.10^6$A/cm$^2$ pour des jonctions tunnels simples à aimantation planaire. Par contre, si on utilise une nanostructure d'aimantation perpendiculaire dans laquelle on injecte un courant de spin de polarisation perpendiculaire, la densité de courant de commutation devient

$$J_{WR\,out-of-plane} = \left(\frac{2e}{\hbar}\right)\frac{2\alpha\, t_F}{P}K_{eff} \quad \text{dans laquelle}$$

$K_{eff}$ représente l'anisotropie effective de la nanostructure. Cette anisotropie effective englobe l'anisotropie de forme (c'est-à-dire de champ démagnétisant) qui tend à ramener l'aimantation dans le plan de la couche, et l'anisotropie perpendiculaire (d'origine volumique ou interfaciale) qui tend à tirer l'aimantation hors du plan. Il s'en suit que cette anisotropie effective $K_{eff}$ est en général bien plus faible que le terme $\dfrac{\mu_0 M_S^2}{2} + 2K$ gouvernant

le courant critique dans le cas planaire. En conséquence, on peut s'attendre à obtenir des courants critiques en anisotropie perpendiculaire plus faible que pour les matériaux à aimantation planaire. De récents résultats expérimentaux (Yoda et al, présentés oralement à Intermag 2008, Madrid, FA04) ont montré dans des structures à aimantation perpendiculaire du type Tb-Co/CoFeB2nm/MgO/CoFeB1nm/GdCo des courants critiques de $3.10^6 A/cm^2$. Ce résultat est encourageant mais encore trop important ce qui semble indiquer que le rapport $\alpha/P$ est supérieur dans ces matériaux à aimantation hors du plan qu'avec les matériaux « usuels » à aimantation planaire. Il reste donc à trouver des matériaux à aimantation perpendiculaire ayant un faible amortissement de Gilbert et une forte polarisation en spin et offrant une grande amplitude de magnétorésistance (seulement 10% dans l'étude précitée). Par ailleurs, cette configuration ne résout également pas le problème des fluctuations stochastiques du temps de retournement de l'aimantation.

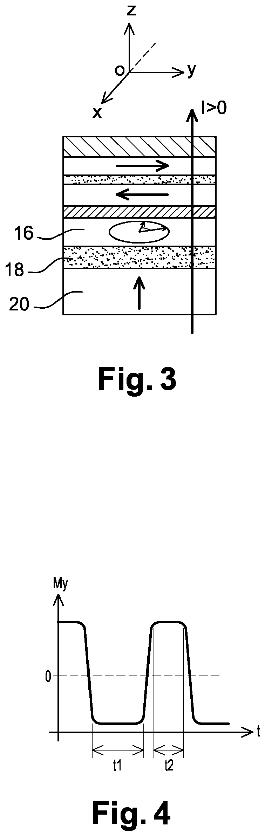

Une autre approche proposée dans le brevet FR2817998 consiste, pour provoquer la commutation d'une couche magnétique d'aimantation planaire, à injecter dans cette couche un courant polarisé en spin dont la direction de polarisation est perpendiculaire au plan des couches. Un tel dispositif magnétique 30 est illustré en figure 2. Le dispositif 30 représenté comprend une couche antiferromagnétique 10, un empilement tri-couche 12 constitué par deux couches magnétiques 121, 123 à aimantations planaires antiparallèles, séparées par une couche conductrice non magnétique 122. Cet empilement constitue la couche piégée. Le dispositif 30 comprend en outre une couche isolante 14, et une couche magnétique libre 16. L'ensemble 12, 14, 16 constitue une jonction tunnel magnétique 15. Le dispositif 30 se complète par une couche séparatrice non-magnétique conductrice 18 et une couche magnétique de polarisation 20 ayant une aimantation perpendiculaire au plan de la couche. Cette couche 20 peut être composée d'un empilement de couches, par exemple en Fe/Pt ou en Fe/Pd ou en Co/Pt, ou en Co/Pd, ou en Co/Au, etc... ou en leurs alliages ordonnés. La couche de polarisation repose sur un substrat conducteur 22. L'ensemble de cet empilement est inséré entre une amenée de courant 24 et un transistor 26 de commutation de courant. Pour les électrons transmis à travers la couche 20 ou réfléchis par celle-ci, la direction du spin se trouvera être orientée parallèlement à l'aimantation de cette couche, c'est-à-dire perpendiculairement au plan des diverses couches de la jonction 15 et en particulier au plan de la couche libre 16. L'aimantation de cette couche soumise à ce courant d'électrons polarisés hors du plan va tourner suivant un cône de grand angle d'axe perpendiculaire au plan de la couche, sans pouvoir s'aligner avec la direction de spin du fait du champ démagnétisant qui tend à maintenir l'aimantation dans le plan de la couche. La figure 3 montre symboliquement cette rotation avec une direction positive du courant. Un trièdre trirectangle Oxyz permet de repérer les différentes directions, l'axe Oz étant perpendiculaire au plan des couches. Dans ce brevet FR2817998, il était supposé que la couche 20 à aimantation hors du plan influençait la dynamique de l'aimantation de la couche 16 de façon beaucoup plus importante que la couche de référence 123. En d'autres termes, la couche 20 est principalement responsable du mouvement de précession de la couche 16 lorsqu'un courant d'intensité supérieure au courant critique de précession circule à travers la structure, tandis que la couche 123 ne vient que légèrement perturber ce mouvement de précession en le rendant asymétrique, favorisant un alignement parallèle des aimantations des couches 123 et 16 si le courant est positif et antiparallèle si le courant est négatif. Dans le cas de la figure 3, le courant étant positif, l'état parallèle est donc favorisé. Ceci est représenté sur la figure 4 par une variation alternative de l'aimantation My de la couche 16 présentant des maximas d'aimantation My plus courts (de durée t2) et des minimas d'aimantation My plus longs (de durée t3). Ainsi dans ce brevet, on peut écrire l'état parallèle des aimantations des couches 16 et 123 (représentant par exemple un « 0 ») ou l'état antiparallèle d'aimantation (représentant par exemple un « 1 ») en utilisant l'un ou l'autre des sens du courant mais on est obligé de contrôler précisément la durée du pulse du courant pour s'arrêter soit sur un plateau bas (« 0 »), soit sur un plateau haut (« 1 »).

Selon cette géométrie, l'effet du transfert de spin est de faire précesser l'aimantation sur un cône, autour d'un axe perpendiculaire au plan des couches. Ainsi, lorsqu'un courant continu traverse la structure, l'aimantation de la couche libre 16 précesse de façon continue (c'est-à-dire qu'elle tourne sur elle-même de façon continue avec une oscillation entretenue de My et donc de la résistance de la jonction). On notera que si le dispositif 30 comportait seulement le polariseur perpendiculaire 20 et la couche douce 16 dont l'aimantation précesse, aucune variation de résistance de l'empilement ne se produirait associé à ce mouvement de précession car l'angle entre les aimantations du polariseur perpendiculaire et de la couche douce est constant au cours du mouvement de précession. Pour obtenir un effet de magnétorésistance utilisable dans une application MRAM ou un oscillateur radiofréquence, on est obligé de rajouter la couche de référence piégée 123 d'aimantation planaire, séparée de la couche douce 16 par un espaceur non-magnétique. En contrôlant la durée du mouvement de précession généré par le polariseur perpendiculaire à une demi-période près, il est possible d'utiliser le mouvement de précession pour faire commuter l'aimantation de la couche 16 d'aimantation planaire entre deux directions opposées. L'avantage de cette approche est que la commutation est en principe très rapide (de l'ordre de 0.3ns) et peu sensible aux fluctuations stochastiques. Toutefois, les fréquences de précession en jeu sont typiquement de plusieurs GHz. Cela signifie que pour faire effectuer une demie période de précession à l'aimantation de la couche planaire, il faut pouvoir contrôler la durée de pulse de courant traversant cette couche avec une précision de l'ordre de 0.1 ns. Dans un dispositif électronique de type puce mémoire, cela est très difficile à réaliser car les effets inductifs et capacitifs qui se produisent lors de la propagation des pulses de courant dans les lignes conductrices conduisent à des retards et élargissement des puises. Ces déformations du signal électrique sont rédhibitoires pour la mise en œuvre de cette commutation précessionnelle dans un dispositif mémoire. Un autre dispositif connu est divulgué par US 2009 / 0015958 A1.

Dans ce contexte, la présente invention a pour but de fournir un dispositif magnétique permettant de s'affranchir des exigences précitées sur la durée d'impulsion de courant traversant le dispositif liée aux fréquences de précession élevées tout en réduisant les fluctuations stochastiques de durée de retournement d'aimantation et la densité de courant critique pour le retournement d'aimantation.

A cette fin, l'invention propose un dispositif magnétique comportant :

- une première couche magnétique, dite couche de référence, ayant une aimantation de direction fixe située soit dans le plan de la couche de référence soit perpendiculairement au plan de la couche de référence;
- une seconde couche magnétique, dite couche de stockage, ayant une aimantation de direction variable ;
- une couche non magnétique, dit espaceur, séparant ladite couche de référence et ladite couche de stockage ;
- une troisième couche magnétique, dite couche de polarisation de spin d'électrons, ayant une aimantation perpendiculaire à celle de ladite couche de référence et située hors du plan de la couche de polarisation si l'aimantation de la couche de référence est orientée dans le plan de la couche de référence ou dans le plan de la couche de polarisation si l'aimantation de la couche de référence est orientée perpendiculairement au plan de la couche de référence ;
- des moyens pour faire circuler dans les couches, et perpendiculairement à celles-ci, un courant d'électrons ;

ledit dispositif étant **caractérisé en ce que** ladite aimantation de direction variable possède deux positions d'équilibre sensiblement suivant l'axe défini par ladite direction d'aimantation fixe de ladite couche de référence, le coefficient de transfert de spin entre ladite couche de référence et ladite couche de stockage étant supérieur au coefficient de transfert de spin entre ladite couche de polarisation de spin et ladite couche de stockage de sorte qu'en présence d'un courant d'électrons :

- le transfert de spin entre ladite couche de polarisation de spin et ladite couche de stockage écarte la direction d'aimantation de ladite couche de stockage d'une première position d'équilibre parallèle ou antiparallèle à la direction d'aimantation de ladite couche de référence puis,
- le transfert de spin entre ladite couche de référence et ladite couche de stockage entraîne en fonction de la direction du courant d'électrons :

  ○ soit la commutation de la direction d'aimantation de ladite couche de stockage vers une deuxième position d'équilibre correspondant à une direction d'aimantation de ladite couche de stockage opposée à la direction d'aimantation de ladite couche de stockage dans ladite première position d'équilibre si la direction du courant d'électrons est dans un premier sens ;
  ○ soit le retour de la direction d'aimantation de ladite couche de stockage vers sa direction d'aimantation dans ladite première position d'équilibre si la direction du courant d'électrons est dans un sens opposé au premier sens.

De façon générale, le coefficient $a_j$ de transfert de spin est défini via le couple T exercé par le courant de spin sur l'aimantation locale donné par l'équation: T = $a_j$M×(M×P) où P est un vecteur unitaire orienté dans le sens du courant polarisé en spin et M est le vecteur d'aimantation de la couche de stockage.

Conformément à l'usage, un élément magnétorésistif qui comporte au moins une couche ferromagnétique dure et une couche ferromagnétique douce séparées par une couche intercalaire non ferromagnétique (métallique ou isolante) est appelé « empilement magnétorésistif » ou « jonction tunnel magnétique ». Dans ce qui suit, on désignera cet élément par le terme « empilement magnétorésistif ».

Le dispositif selon l'invention comprend une couche magnétique de stockage à aimantation réorientable entre deux directions sensiblement opposées soit dans le plan, soit hors du plan, en sandwich entre deux couches magnétiques d'aimantation fixe, l'une orientée dans le plan des couches, l'autre orientée perpendiculairement au plan des couches. L'information binaire est codée par l'orientation de l'aimantation de la couche de stockage relativement à celle de la couche de référence. La couche de référence est insérée dans un empilement de couches comprenant des moyens pour faire circuler un courant électrique perpendiculairement au plan des couches magnétiques. Le dispositif selon l'invention possède des propriétés magnétorésistives, c'est-à-dire qu'il est tel que les deux états magnétiques stables sont caractérisés par deux valeurs différentes de résistance électrique du dispositif. L'empilement peut être un empilement magnétorésistif, ou une structure métallique ou à chemin de courants confinés à magnétorésistance géante, ou une structure dite filtre à spin comprenant une barrière d'oxyde magnétique. La commutation d'un état magnétique à l'autre se produit par transfert de spin, c'est-à-dire à l'aide d'un courant polarisé en spin traversant la couche de stockage.

Le coefficient de transfert de spin (ou pré-facteur) entre la couche de référence et la couche de stockage est supérieur au coefficient de transfert de spin entre la couche de polarisation de spin et la couche de stockage. En d'autres termes, l'influence du transfert de spin dû à la première couche piégée (couche de référence) est supérieure à l'influence du transfert de spin dû à la deuxième couche piégée (couche de polarisation de spin).

Dans la demande de brevet FR2817998 déjà mentionnée plus haut, la couche de référence ne perturbe que légèrement le mouvement de précession généré par le polariseur perpendiculaire en induisant l'asymétrie des plateaux montrés sur la figure 4. Dans cette demande de brevet FR2817998, le coefficient de transfert de spin provenant du polariseur perpendiculaire est largement supérieur au coefficient de transfert de spin provenant de la couche de référence. Cette couche de référence ne perturbe pas de façon significative la dynamique d'aimantation générée par le polariseur perpendiculaire, son rôle principal consistant à faire apparaître un signal de magnétorésistance. Au contraire, selon la présente invention, le transfert de spin exercé par la couche de référence joue un rôle dominant par rapport au transfert de spin joué par le polariseur perpendiculaire ; c'est la couche de référence qui joue le rôle principal sur la dynamique d'aimantation, la couche de polarisation n'aidant qu'à réduire le courant critique de commutation.

Si la structure magnétorésistive était toute seule, c'est-à-dire sans la couche polariseur à aimantation perpendiculaire, il est alors connu de l'homme du métier qu'on peut faire commuter l'aimantation de la couche de stockage par effet de transfert de spin, c'est-à-dire en faisant circuler un courant polarisé en spin à travers la structure. En fait, les électrons se polarisent en traversant la couche magnétique de référence et exerce un couple magnétique sur l'aimantation de la couche de stockage. Lorsque ce couple est suffisamment fort, l'aimantation de la couche de stockage peut commuter. Il est connu que si les électrons vont de la couche de référence vers la couche de stockage, cela favorise l'alignement parallèle des aimantations. Si au contraire les électrons circulent de la couche de stockage vers la couche de référence, cela favorise l'alignement antiparallèle des aimantations. Partant de cet élément magnétorésistif bistable connu, on rajoute le polariseur perpendiculaire. Ce faisant, on rajoute une deuxième contribution de transfert de spin provenant de la polarisation du courant induite par le polariseur perpendiculaire. Mais on fait en sorte que cette deuxième contribution au transfert de spin exercé sur la couche de stockage soit inférieure à la contribution apportée par la couche de référence. Ainsi, la couche de stockage garde un comportement bistable malgré la présence du polariseur perpendiculaire. En d'autres termes, dans ces conditions et contrairement au dispositif magnétique de la demande de brevet FR2817998, l'aimantation de la couche de stockage ne se trouve pas emportée dans un mouvement de précession entretenue mais continue de commuter par rapport à l'aimantation de la couche de référence comme dans le cas de l'élément magnétorésistif seul, c'est-à-dire vers l'état parallèle si les électrons circulent de la couche de référence vers la couche de stockage et vers l'état antiparallèle si les électrons circulent de la couche de stockage vers la couche de référence. Le bénéfice de l'adjonction de la couche de polarisation perpendiculaire ayant un effet plus faible sur le transfert de spin que la couche de référence est néanmoins double :

- elle permet de baisser de façon très significative la densité de courant critique de commutation (typiquement par un facteur 2 à 10). Le transfert de spin provenant du polariseur perpendiculaire fournit un couple supplémentaire à l'aimantation de la couche de stockage qui vient s'ajouter au couple fourni par la couche de référence et aide ainsi à la commutation de l'aimantation de la couche de stockage. Ainsi la couche de stockage peut commuter à une densité de courant inférieure à la situation où le polariseur perpendiculaire n'est pas présent. Il est à souligner que le polariseur perpendiculaire seul ne suffirait pas dans cette invention, à faire commuter et a fortiori à faire précesser l'aimantation de la couche de stockage ;

- la présence de la couche de polarisation additionnelle permet de réduire les fluctuations stochastiques de temps de commutation de l'aimantation de la couche de stockage. En effet, en l'absence de ce polariseur additionnel, les aimantations des couches de stockage et de référence sont initialement parallèles ou antiparallèles. De ce fait, le couple de transfert de spin exercé au tout début de la commutation est très faible car ce couple varie comme le sinus de l'angle entre les aimantations des couches de référence et de stockage (sinus proche de zéro lorsque les aimantations sont parallèles ou antiparallèles). Du coup, la commutation d'aimantation se déclenche de façon aléatoire lorsqu'une fluctuation thermique écarte l'aimantation de la couche de stockage de sa direction à l'équilibre. Ceci provoque une incertitude dans le temps nécessaire à la commutation d'aimantation qui est gênante dans une perspective d'utilisation de ce phénomène pour l'écriture de cellules MRAM. Par contre, en présence de la couche de polarisation additionnelle, la situation est différente. En effet, l'aimantation de la couche de polarisation est sensiblement orthogonale à celle de la couche de stockage. Le couple de transfert de spin est donc maximal dès le début du pulse de courant d'écriture. En conséquence, bien que ce couple dû au polariseur perpendiculaire soit trop faible pour faire commuter l'aimantation à lui tout seul, il est néanmoins suffisant pour permettre à l'aimantation de subir une impulsion qui l'écarte de sa position d'équilibre en un très bref temps de l'ordre de 50ps. De ce fait, ceci permet au transfert de spin dû à la couche de référence de prendre très rapidement la relève et de provoquer la commutation de l'aimantation de la couche de stockage. Ainsi, grâce à la couche de polarisation, le retournement n'est plus déclenché par une fluctuation thermique aléatoire mais par le pulse de courant lui-même traversant l'élément magnétique. Ceci rend la commutation beaucoup plus rapide et sa durée beaucoup moins fluctuante.

A aucun moment, en présence d'un courant continu, l'aimantation de la couche de stockage ne précesse, et donc n'oscille, de façon continue. Une fois que l'aimantation a commuté, elle reste dans le nouvel état et ne continue pas à tourner.

Le dispositif magnétique selon l'invention peut également présenter une ou plusieurs des caractéristiques ci-dessous, considérées individuellement ou selon toutes les combinaisons techniquement possibles :

- ladite couche de stockage présente une anisotropie uniaxiale avec un axe facile d'aimantation sensiblement parallèle à la direction d'aimantation de ladite couche de référence ;
- ladite couche de stockage présente une forme allongée telle qu'une forme elliptique ;
- le dispositif selon l'invention comporte une couche, dite second espaceur, séparant ladite couche de stockage et ladite couche de polarisation de spin d'électrons ;
- la résistance électrique de l'empilement formé par ladite couche de référence, ledit premier espaceur et ladite couche de stockage est supérieure à la résistance électrique de l'empilement formé par ledit second espaceur et ladite couche de polarisation de spin d'électrons ;
- le produit de la résistance par la surface dudit premier espaceur est supérieur au produit de la résistance par la surface dudit second espaceur ;
- ledit premier espaceur est une barrière tunnel et ledit second espaceur est choisi parmi les éléments suivants :

   ○ une barrière tunnel ;
   ○ une barrière à chemins de courant confinés ;

   ○ une couche métallique non magnétique ;

- ledit premier espaceur est une barrière à chemins de courant confinés et ledit second espaceur est choisi parmi les éléments suivants :

   ○ une barrière à chemins de courant confinés ;
   ○ une couche métallique non magnétique ;

- ledit second espaceur est une barrière à chemins de courant confinés présentant davantage de chemins métalliques et/ou des chemins magnétiques de diamètres plus grands que dans le premier espaceur ;
- lesdits premier et second espaceurs sont des couches métalliques non magnétiques ;
- ladite couche de polarisation de spin d'électrons est directement couplée à ladite couche de stockage ;
- ladite couche de référence a une aimantation de direction fixe située dans le plan de la couche de référence et ladite couche de polarisation de spin d'électrons a une aimantation perpendiculaire à celle de ladite couche de référence et située hors du plan de la couche de polarisation ;
- ladite couche de polarisation de spin d'électrons est réalisée suivant l'un des agencements suivants :

   ○ une multicouche de période (Pt/Co), (Pd/Co) ou (Pt/Co/Pt/Ni) ;
   ○ une multicouche formée d'une alternance de couches ultrafines de Co et de Ni ;
   ○ une multicouche formée par une alternance métal de transition magnétique/oxyde ;
   ○ un alliage ordonné FePt ou FePd ;
   ○ un alliage CoPt ou CoPd avec des concentrations de Co entre 85% atomique et 50% atomique ;
   ○ un alliage CoCr de structure hexagonale avec axe c perpendiculaire au plan des couches ;
   ○ un alliage terre-rare/métal de transition ;

- ladite couche de stockage est réalisée dans l'un des matériaux suivants :

   ○ un alliage à base de Co, Fe, Ni contenant des additifs en particulier de B, Cr, Pt, Pd, Zr, Nb ;
   ○ un alliage d'Heusler ;

- ladite couche de référence est réalisée suivant l'un des matériaux suivants :

   ○ un alliage à base de Co, Fe, Ni contenant des additifs, en particulier du B, Cr, Pt, Pd, Zr, Nb ;
   ○ un matériau demi-métallique en particulier de la famille des alliages d'Heusler ;

- ladite couche de référence a une aimantation de direction fixe perpendiculairement au plan de la couche de référence et ladite couche de polarisation de spin d'électrons a une aimantation perpendiculaire à celle de ladite couche de référence et située dans le plan de la couche de polarisation ;

- ladite couche de polarisation de spin d'électrons est réalisée dans l'un des matériaux suivants :

   ◦ un alliage à base de Co, Fe, Ni contenant des additifs, en particulier du B, Cr, Pt, Pd, Zr, Nb ;
   ◦ une multicouche de Co contenant de fines insertions de Cu ou de Ni ;
   ◦ un matériau demi-métallique en particulier de la famille des alliages d'Heusler ;

- ladite couche de stockage et/ou ladite couche de référence sont réalisées suivant l'un des agencements ou matériaux suivants :

   ◦ une multicouche de période (Pt/Co), (Pd/Co) ou (Pt/Co/Pt/Ni) ;
   ◦ une multicouche formée d'une alternance de couches de Co et de Ni ;
   ◦ une multicouche alternant un métal de transition magnétique et un oxyde ;
   ◦ un alliage ordonné de FePt ou de FePd ;
   ◦ un alliage de CoPt ou de CoPd avec des concentrations de Co entre 85% atomique et 50% atomique;
   ◦ un alliage de CoCr de structure hexagonale avec axe c perpendiculaire au plan des couches ;
   ◦ un alliage terre-rare/métal de transition ;

- au moins l'une desdites couches de référence, de stockage ou de polarisation de spin d'électrons est une couche antiferromagnétique synthétique formée de deux couches d'aimantation fixe orientée hors du plan et couplées antiparallèlement par une couche apte à induire un couplage antiferromagnétique entre les couches ferromagnétiques ;
- au moins l'une desdites couches de référence ou de polarisation de spin d'électrons présente une aimantation piégée par interaction avec une couche antiferromagnétique de piégeage.

La présente invention a également pour objet un procédé d'écriture/lecture d'information dans un dispositif selon l'invention caractérisé en ce que l'écriture d'information consiste à faire circuler à travers le dispositif perpendiculairement au plan des couches un courant d'électrons, la commutation de la direction d'aimantation de ladite couche de stockage vers la deuxième position d'équilibre se faisant par l'injection d'un courant d'électrons dans un premier sens et la commutation de la direction d'aimantation de ladite couche de stockage vers la première position d'équilibre se faisant par l'injection d'un courant d'électrons dans un deuxième sens opposé au dit premier sens du courant.

Avantageusement, la lecture d'information consiste à faire circuler à travers le dispositif perpendiculairement au plan des couches un courant d'électrons et à mesurer la résistance dudit dispositif, l'intensité du courant de lecture étant inférieure à l'intensité du courant d'écriture.

D'autres caractéristiques et avantages de l'invention ressortiront clairement de la description qui en est donnée ci-dessous, à titre indicatif et nullement limitatif, en référence aux figures annexées, parmi lesquelles :

- la figure 1 représente schématiquement un ensemble de jonctions tunnel magnétiques dans un dispositif mémoire illustrant la structure et la fonction d'une jonction tunnel magnétique ;
- la figure 2 illustre un dispositif magnétique selon l'état de la technique ;
- la figure 3 montre les orientations des aimantations dans les différentes couches selon une direction positive de circulation du courant pour le dispositif de la figure 2 ;
- la figures 4 montre les variations de la composante de l'aimantation selon un axe Oy parallèle au plan des couches suivant la direction du courant circulant à travers l'empilement illustré en figure 3 ;
- la figure 5 représente schématiquement un dispositif selon l'invention ;
- la figure 6 représente une vue de dessus de la couche de stockage utilisée dans le dispositif de la figure 5 ;
- les figures 7A et 7B représentent les variations de la composante My de l'aimantation selon un axe Oy parallèle au plan des couches du dispositif de la figure 5 ;
- la figure 8 représente un exemple de diagramme de stabilité (courant-champ) d'un dispositif selon l'invention ;
- la figure 9 représente un premier mode de réalisation de l'invention ;
- la figure 10 représente un second mode de réalisation de l'invention ;
- la figure 11 représente un troisième mode de réalisation de l'invention ;
- la figure 12 représente un quatrième mode de réalisation de l'invention ;
- la figure 13 représente un cinquième mode de réalisation de l'invention.

Les figures 1 à 4 ont déjà été décrites en référence à l'état de la technique.
Un trièdre trirectangle Oxyz permet de repérer les différentes directions, l'axe Oz étant perpendiculaire au plan des couches.

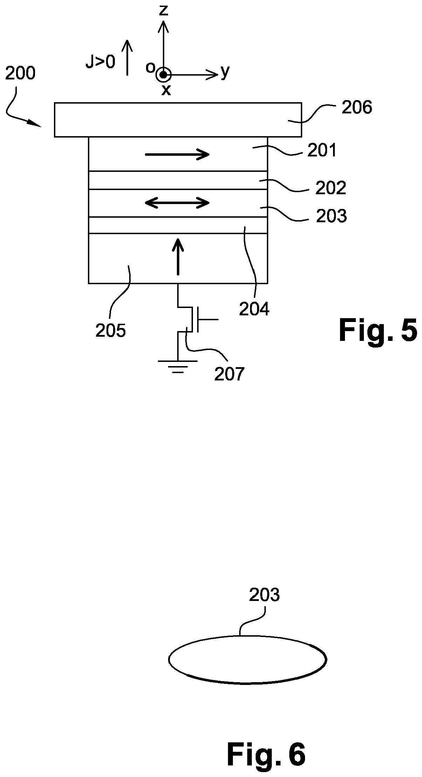

La figure 5 représente schématiquement un dispositif magnétique 200 selon l'invention.
Le dispositif magnétique 200 comporte :

- une couche magnétique de référence 201 de direction d'aimantation fixe (ici située dans le plan de la couche de référence) ;

- un premier espaceur non magnétique 202 ;
- une couche magnétique de stockage 203 de direction d'aimantation réorientable suivant deux états d'orientation sensiblement opposées (deux positions d'équilibre sensiblement suivant l'axe défini par la direction d'aimantation fixe de la couche de référence 201) ;
- un second espaceur 204 ;
- une couche 205 de polarisation de spin d'électrons, ayant une aimantation hors du plan de la couche de polarisation et de direction perpendiculaire à celle de la couche de référence 200.

Cet empilement formé par l'ensemble de couches ci-dessus est inséré entre une amenée de courant 206 et un moyen de commutation de courant 207 qui est ici un transistor permettant de faire circuler un courant électrique perpendiculairement au plan de l'empilement de couches magnétiques.

L'empilement possède des propriétés magnétorésistives c'est-à-dire qu'il est tel que les deux états magnétiques stables sont caractérisés par deux valeurs différentes de résistance électrique de la structure. L'empilement peut être un empilement magnétorésistif, ou une structure métallique ou à chemin de courants confinés à magnétorésistance géante, ou une structure dite filtre à spin comprenant une barrière d'oxyde magnétique. La commutation d'un état magnétique à l'autre se produit par transfert de spin, c'est-à-dire à l'aide d'un courant polarisé en spin traversant la couche de stockage 203.

Le second espaceur 204 présente une résistance inférieure à celle de l'élément magnétorésistif formé par la couche de référence 201 et la couche de stockage 203 séparées par le premier espaceur non magnétique 202. La résistance électrique du deuxième espaceur 204 doit en effet être suffisamment faible par rapport à celle de l'élément magnétorésistif de sorte que l'effet de magnétorésistance du dispositif 200 ne soit pas trop réduit par la résistance en série de l'espaceur 2. Le second espaceur 204 est en contact avec la couche de stockage 203 du côté opposé de l'élément magnétorésistif.

La couche 205 de polarisation de spin d'électrons est en contact avec le second espaceur 204.

La couche de référence 201 et la couche de polarisation de spin d'électrons 205 sont choisies de sorte que le coefficient de transfert de spin entre la couche de référence 201 et la couche de stockage 203 soit supérieur au coefficient de transfert de spin entre la couche de polarisation de spin 205 et la couche de stockage 203.

La couche de stockage 203 présente préférentiellement une anisotropie uniaxiale pouvant être générée en donnant à la structure une forme allongée elliptique. Cette anisotropie uniaxiale confère à l'aimantation de la couche de stockage 203 deux états stables d'aimantation sensiblement parallèle et antiparallèle à l'aimantation de la couche de référence 201. La figure 6 montre une vue de dessus de la couche de stockage 203 présentant une forme elliptique.

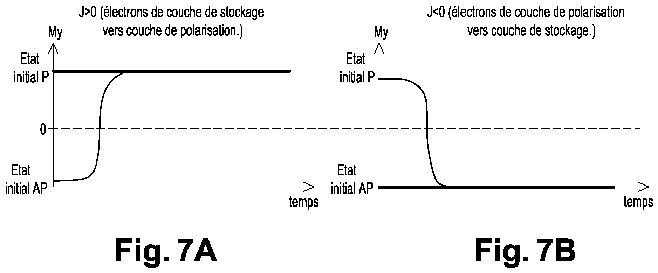

Si l'élément magnétorésistif formé par la couche de référence 201 et la couche de stockage 203 séparées par le premier espaceur non magnétique 202 était tout seul, c'est-à-dire sans le second espaceur 204 et la couche de polarisation perpendiculaire 205, on peut faire commuter l'aimantation de la couche de stockage 203 par effet de transfert de spin, c'est-à-dire en faisant circuler un courant polarisé en spin à travers la structure. En fait, les électrons se polarisent en traversant la couche magnétique de référence 201 et exerce un couple magnétique sur l'aimantation de la couche de stockage 203. Lorsque ce couple est suffisamment fort, l'aimantation de la couche de stockage 203 peut commuter. Si les électrons vont de la couche de référence 201 vers la couche de stockage 203, cela favorise l'alignement parallèle des aimantations. Si au contraire les électrons circulent de la couche de stockage 203 vers la couche de référence 201, cela favorise l'alignement antiparallèle des aimantations. Ceci est décrit par exemple dans l'article Y.Huai et al (Applied Physics Letters 84, 3118 (2004)). Dans ce cas, les densités de courant critique de commutation sont typiquement de l'ordre de $5.10^6 A/cm^2$ en quasistatique, atteignant de l'ordre de $2.10^7 A/cm^2$ pour une commutation par impulsion de courant d'une durée de l'ordre de la nanoseconde. Ces densités de courant sont relativement élevées pour une utilisation pour une application MRAM. Elles imposent une taille du transistor 207 de sélection connecté en série avec l'élément magnétorésistif, bien supérieure à la taille de l'élément magnétorésistif. Par ailleurs, dans le cas où l'élément magnétorésistif est un empilement magnétorésistif de produit RA (résistance R par surface A) typiquement de l'ordre de $5\Omega.\mu m^2$ (valeur permettant d'avoir une magnétorésistance supérieure à 100% pour des empilements magnétorésistifs à base de MgO), des impulsions de densité de courant $j=10^7 A/cm^2$ signifie des impulsions de tension V=RA.j de 1V ce qui est très proche de la tension de claquage électrique de ces empilements magnétorésistifs. On souhaite donc arriver à baisser la densité de courant de commutation pour diminuer le risque de claquage de l'empilement magnétorésistif lors des cycles d'écriture. C'est le but de l'adjonction de la couche de polarisation 205. Partant de l'élément magnétorésistif bistable décrit ci-dessus, on rajoute donc le second espaceur 204 et la couche de polarisation à aimantation perpendiculaire 205. Ce faisant, on rajoute une deuxième contribution de transfert de spin provenant de la polarisation du courant induite par la couche de polarisation perpendiculaire 205. On fait toutefois en sorte que cette deuxième contribution au transfert de spin exercé sur la couche de stockage 203 soit inférieure à la contribution apportée par la couche de référence 201. Ainsi, la couche de stockage 203 garde un comportement bistable malgré la présence de la couche de polarisation perpendiculaire 205. Dans ces conditions, l'aimantation de la couche de stockage 203 ne se trouve pas emportée dans un mouvement de précession entretenue mais continue de commuter par rapport à l'aimantation de la couche de référence comme dans le cas de l'élément magnétorésistif seul, c'est-à-dire vers l'état parallèle si les électrons circulent de la couche de référence vers la couche de stockage et vers l'état antiparallèle si les électrons circulent de la couche de stockage vers la couche de référence. Ce phénomène est illustré aux figures 7A et 7B qui représente les variations de la composante My de l'aimantation selon un axe Oy parallèle au plan des couches en fonction du temps selon que les couches sont parcourues par un courant continu positif ou négatif (J>0 ou J<0). P et AP désignent respectivement les états initiaux parallèle ou antiparallèle entre la direction d'aimantation de la couche de référence 201 et la direction d'aimantation de la couche de stockage 203. On constate bien un comportement bistable. On favorise (figure 7 A) l'état parallèle en faisant passer les électrons de la couche de référence 201 vers la couche de stockage 203 : en d'autres termes, si l'état initial est AP, le fait de faire passer un courant J>0 entraîne une transition vers l'état P ; si l'état initial est P, on reste à l'état P lorsqu'on fait passer un courant J>0. Inversement, on favorise (figure 7 B) l'état antiparallèle en faisant passer les électrons de la couche de stockage vers la couche de référence. Une fois que l'aimantation a commuté, elle reste dans le nouvel état et ne continue pas à tourner comme dans les documents de l'art antérieur (et notamment la demande de brevet FR2817998). Lorsqu'elle est traversée par un courant continu perpendiculaire à ses interfaces, une structure de l'état antérieur avec un polariseur perpendiculaire présente des oscillations entretenues de My c'est-à-dire de résistance. Par contre, le dispositif selon la présente invention possède une résistance sensiblement invariante ou sensiblement en marche d'escalier suivant l'état magnétique initial et suivant la direction du courant comme représenté sur les graphiques des figures 7A et 7B.

Le bénéfice de l'adjonction de la couche de polarisation 205 à aimantation perpendiculaire est double :

- Il permet de baisser la densité de courant critique de commutation (typiquement par un facteur 2 à 10). Le transfert de spin provenant de la couche de polarisation 205 fournit un couple supplémentaire à l'aimantation de la couche de stockage 203 qui vient s'ajouter au couple fourni par la couche de référence 201 et aide ainsi à la commutation de l'aimantation de la couche de stockage 203. Ainsi la couche de stockage 203 peut commuter à une densité de courant inférieure à la situation où la couche de polarisation 205 n'est pas présente. Il convient de noter que la couche de polarisation 205 seule ne suffirait pas à faire commuter et a fortiori à faire précesser l'aimantation de la couche de stockage 203 ;
- la présence de la couche de polarisation 205 permet de réduire les fluctuations stochastiques de temps de commutation de l'aimantation de la couche de stockage 203. En effet, en l'absence de cette couche de polarisation 205, les aimantations des couches de stockage et de référence sont initialement parallèles ou antiparallèles. De ce fait, le couple de transfert de spin exercé au tout début de la commutation est très faible car ce couple varie comme le sinus de l'angle entre les aimantations des couches de référence et de stockage (sinus qui est égal à zéro lorsque l'état est parallèle ou antiparallèle). Dès lors, en l'absence de la couche de polarisation 205, la commutation d'aimantation se déclenche de façon aléatoire lorsqu'une fluctuation thermique écarte l'aimantation de la couche de stockage de sa direction à l'équilibre. En revanche, en présence de la couche de polarisation 205, la situation est différente. En effet, l'aimantation de la couche de polarisation 205 est sensiblement orthogonale à celle de la couche de stockage 203. Le couple de transfert de spin est donc maximal dès le début de l'injection de l'impulsion de courant d'écriture. En conséquence, bien que ce couple dû à la couche de polarisation 205 soit trop faible pour faire commuter l'aimantation à elle toute seule, elle est néanmoins suffisante pour permettre à l'aimantation de subir une impulsion qui l'écarte de sa position d'équilibre en un très bref temps de l'ordre de 50ps. De ce fait, ceci permet au transfert de spin dû à la couche de référence 201 de prendre très rapidement la relève et de provoquer la commutation de l'aimantation de la couche de stockage 203. Ainsi, grâce à la couche de polarisation 205, le retournement n'est plus déclenché par une fluctuation thermique aléatoire mais par l'impulsion de courant elle-même traversant l'élément magnétique. Ceci rend la commutation beaucoup plus rapide et sa durée beaucoup moins fluctuante.

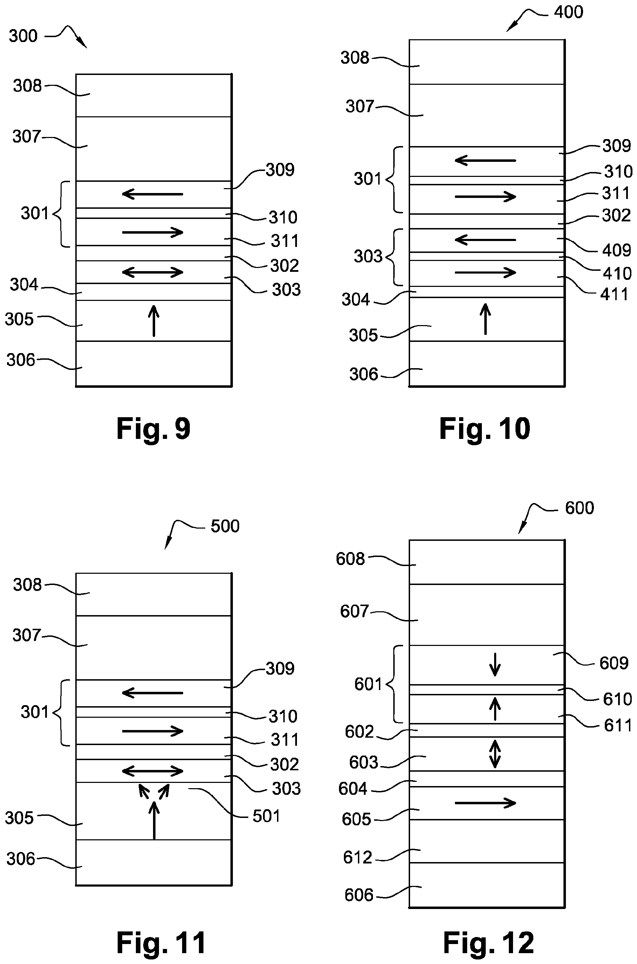

Nous verrons en référence à la figure 11 qu'il est possible d'omettre le second espaceur 204, la couche 205 de polarisation de spin d'électrons, ayant une aimantation hors du plan de la couche de polarisation et de direction perpendiculaire à celle de la couche de référence 201 étant alors directement couplée à la couche de stockage 203.

La couche de stockage 203 peut être une couche magnétique simple (par exemple en CoFeB) ou constituée de plusieurs couches magnétiques couplées (par exemple CoFe/CoFeB). La couche de stockage 203 peut également être une couche antiferromagnétique synthétique c'est-à-dire constituée de deux couches ferromagnétiques couplées antiparallèlement à travers une fine couche de couplage antiparallèle, par exemple en ruthénium d'épaisseur 0.6nm à 0.8nm. L'avantage d'une telle structure est de présenter une meilleure stabilité thermique vis-à-vis des fluctuations thermiques d'aimantation.

La couche de référence 201 peut être une couche simple piégée par une couche antiferromagnétique. La couche de référence peut être un alliage à base de Co, Fe, Ni contenant des additifs en particulier de B, Cr, Pt, Pd, Zr, Nb. La couche de référence peut aussi être réalisée en un matériau demi-métallique en particulier de la famille des alliages d'Heusler tels que Ni2MnAl, Ni2MnIn, Ni2MnSn, Ni2MnSb, Co2MnAl, Co2MnSi, Co2MnGa, Co2MnGe. Dans le cas d'empilement magnétorésistif à base de MgO bcc, cette couche doit aussi, de façon préférentielle, avoir près de l'interface une structure cubique centrée bcc (« body cubic centered » en anglais). On choisit alors un alliage à base de Co, de Fe et de Ni de structure bcc ou un alliage CoFeB amorphe que l'on recuira ensuite. Les alliages d'Heusler cités ci-dessus peuvent aussi convenir. La couche de référence peut être aussi avantageusement une couche antiferromagnétique synthétique constituée de deux couches ferromagnétiques couplées antiparallèlement à travers une fine couche de couplage antiparallèle, par exemple en ruthénium d'épaisseur 0.6nm à 0.8nm. Cette couche antiferromagnétique synthétique peut elle-même être piégée par interaction avec une couche antiferromagnétique. L'avantage d'utiliser une couche piégée synthétique est de pouvoir diminuer le champ magnétostatique rayonné par la couche de référence sur la couche de stockage et éviter de privilégier ainsi une orientation de l'aimantation de la couche de stockage par rapport à l'autre.

La couche de polarisation de spin d'électrons 205 peut également être une couche antiferromagnétique synthétique. Elle peut aussi être piégée par une couche antiferromagnétique.

On notera qu'au lieu d'utiliser des couches à aimantation planaire pour la couche de stockage 203 et la couche de référence 201 et une couche à aimantation hors du plan, perpendiculaire à l'aimantation de la couche de stockage 203, pour la couche de polarisation de spin d'électrons 205, il est possible de tourner toutes ces aimantations de 90° c'est-à-dire d'utiliser des couches à aimantation hors du plan pour la couche de stockage 203 et la couche de référence 201 et une couche à aimantation planaire pour la couche de polarisation de spin d'électrons 205.

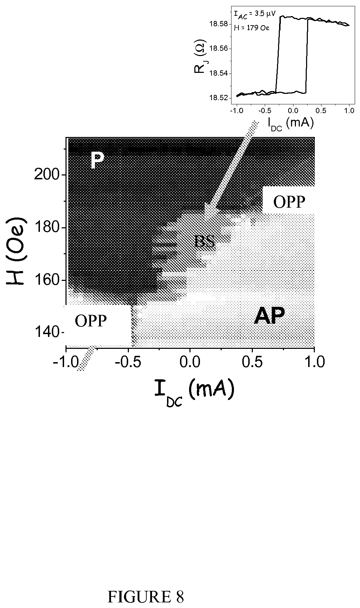

Le diagramme de stabilité (courant-champ) d'un dispositif selon l'invention est représenté sur la figure 8 avec une courbe R(I) illustrant l'évolution de la résistance en fonction du courant.

On observe clairement cinq zones :

- une première zone noire P correspondant à un état parallèle de l'aimantation de la couche de stockage 203 ;
- une seconde zone en gris foncé BS de bi-stabilité de l'aimantation de la couche de stockage 203 ;
- une troisième zone en gris clair correspondant à un état antiparallèle de l'aimantation de la couche de stockage 203 ;
- une quatrième et une cinquième zone OPP (pour « Out of Plane Precession » en anglais) de précession de l'aimantation de la couche de stockage 203.

On observe donc une zone centrale BS de bi-stabilité Parallèle (P)/Antiparallèle (AP) ayant une forme « d'amande » qui se termine par des régions étroites en courant où il est facile de commuter de l'état P à AP et de l'état AP à P avec de relativement faibles variations de courant. C'est cette forme particulière du diagramme de phase obtenue en combinant une couche de référence 201 jouant un rôle dominant dans la dynamique d'aimantation et une couche de polarisation perpendiculaire 205 jouant un rôle secondaire qui permet d'obtenir la propriété de bi-stabilité associée à une densité de courant critique de commutation par transfert de spin bien plus faible que dans l'état de l'art.

Il est à noter que la région de bi-stabilité dans le diagramme de phase représenté sur la figure 8 est centrée autour d'une valeur de champ non-nul (ici égale à 1730e). Ce champ correspond en fait au champ magnétostatique rayonné par la couche de référence 201 sur la couche de stockage 203. Ce champ peut être annulé en utilisant une couche de référence 201 dite antiferromagnétique synthétique, c'est-à-dire formée de deux couches ayant sensiblement un même moment magnétique couplée antiparallèlement l'une à l'autre à travers une couche de ruthénium d'épaisseur typiquement de l'ordre de 0.6nm. Ainsi les champs rayonnés par ces deux couches au niveau de la couche de stockage se compensent, ce qui permet de recentrer autour du champ nul la région de bi-stabilité.

Le cycle d'hystérésis R(I) présenté en haut à droite sur la figure 8 présente un courant de commutation correspondant à une densité de courant de l'ordre de $2.10^6$A/cm$^2$ soit un ordre de grandeur en dessous de ce même dispositif sans couche de polarisation perpendiculaire. Ce cycle correspond aux valeurs de la résistance du dispositif 200 en fonction du courant qui le traverse lorsqu'on se déplace sur une ligne horizontale correspondant à un champ de 1790e dans le diagramme de stabilité et permet d'observer les deux valeurs stables de résistance dans la zone de bi-stabilité BS correspondant aux états P et AP.

Selon la présente invention, le coefficient de transfert de spin entre la couche de référence 201 et la couche de stockage 203 doit être supérieur au coefficient de transfert de spin entre la couche de polarisation de spin 205 et la couche de stockage 203. Pour ce faire, plusieurs solutions sont possibles :

- On peut jouer sur la forme de l'élément magnétique et plus généralement sur son anisotropie uniaxiale. On aura intérêt à donner à la couche de stockage 203 une anisotropie uniaxiale avec un axe facile d'aimantation sensiblement parallèle à la direction d'aimantation de la couche de référence. Comme évoqué précédemment, cette anisotropie uniaxiale peut être une anisotropie de forme obtenue en donnant à l'élément une forme allongée (elliptique, rectangulaire, hexagonale étirée...). Il peut aussi s'agir d'une anisotropie magnétocristalline si la couche est épitaxiée avec un axe facile selon la couche de référence 201 ou polycristalline mais avec une texture de grains donnant une anisotropie uniaxiale sensiblement parallèle à l'aimantation de la couche de référence 201. On peut aussi induire une anisotropie uniaxiale par dépôt en incidence oblique comme décrit par exemple dans l'article « Influence of déposition angle on the properties of NiO spin-valves » (M.Cartier, S.Auffret, P.Bayle-Guillemaud, F.Ernult, F.Fettar and B.Dieny, Journal-of-Applied-Physics. vol.91, no.3; 1 Feb. 2002; p.1436-43).

- On peut également jouer sur la polarisation du courant provenant de la couche de polarisation perpendiculaire 205. Il est possible d'atténuer la polarisation du courant en introduisant des couches de Pt ou de Mn dans la couche de polarisation, lesquelles sont connues pour générer du spin flip ce qui peut contribuer à baisser l'influence du transfert de spin de la couche de polarisation perpendiculaire sur la couche de stockage. Il ne faut cependant pas trop baisser cette contribution pour que l'effet bénéfique de la couche de polarisation perpendiculaire subsiste.
- On peut aussi augmenter le rôle du transfert de spin exercé par la couche de référence 201 sur la couche de stockage 203. Pour cela, l'utilisation de couches de référence 201 et/ou de couche non magnétique 202 à barrière tunnel donnant une forte polarisation en spin des électrons tunnels est préférable. Les barrières tunnel de MgO associées à des électrodes de Co, CoFe ou CoFeB sont connues pour donner de telles polarisations importantes. Il est aussi possible d'utiliser une électrode de référence à base de matériaux demi-métalliques comme les alliages d'Heusler.

Par soucis de simplification, les amenées de courant et les moyens de commutation de courant permettant de faire circuler un courant électrique perpendiculairement au plan de l'empilement de couches magnétiques ont été volontairement omis dans la description des figures 9 à 13 qui suivent.

La figure 9 représente un premier mode de réalisation d'un dispositif magnétique 300 selon l'invention.

Le dispositif magnétique 300 comporte un empilement formé par:

- une couche de protection 308 ;
- une couche de piégeage antiferromagnétique 307 ;
- une couche magnétique de référence 301 de direction d'aimantation fixe (ici située dans le plan de la couche de référence) ;
- un premier espaceur non magnétique 302 ;
- une couche magnétique de stockage 303 de direction d'aimantation réorientable suivant deux états d'orientation sensiblement opposées (deux positions d'équilibre sensiblement suivant l'axe défini par la direction d'aimantation fixe de la couche de référence 301) ;
- un second espaceur 304 ;
- une couche 305 de polarisation de spin d'électrons, ayant une aimantation hors du plan de la couche de polarisation et de direction perpendiculaire à celle de la couche de référence 301 ;
- une couche tampon 306.

La couche de référence 301 est ici une couche antiferromagnétique synthétique comprenant deux couches ferromagnétiques 311 et 309 couplées antiparallèlement à travers une fine couche 310 de couplage antiparallèle, par exemple en ruthénium d'épaisseur 0.6nm à 0.8nm. Dans le cas où le premier espaceur non magnétique 302 est une barrière tunnel de MgO, cette couche de référence 301 antiferromagnétique synthétique comprend une couche 311 de CoFeB d'épaisseur entre 1.5 et 4nm en contact avec la barrière 302 de MgO, une couche 310 de ruthénium d'épaisseur entre 0.6 et 0.9nm et une couche 309 de CoFe d'épaisseur typique de 2 à 4nm. Cette dernière couche magnétique 309 est ici piégée par la couche antiferromagnétique 307 par exemple en Ir20Mn80 d'épaisseur 7nm ou en PtMn d'épaisseur 20nm.

La couche de piégeage antiferromagnétique 307 est recouverte par la couche de protection 308 servant à la protéger de l'oxydation lors de l'exposition à l'air pendant le procédé de fabrication et servant également de contact électrique avec l'électrode supérieure de l'empilement.

La couche de stockage 303 est une couche à aimantation dans le plan de la couche aimantation de direction variable et possédant deux positions d'équilibre sensiblement suivant l'axe défini par la direction d'aimantation fixe de la couche de référence 301 dont la direction d'aimantation est fixe 301 dans le plan de la couche de référence. La couche de stockage 303 doit présenter une stabilité thermique suffisante pour que l'aimantation puisse rester dans une direction fixe pendant une durée de 10 ans. Cela impose qu'elle ait une anisotropie uniaxiale K telle que $KV>50k_BT$ où V est le volume de cette couche, $k_B$ est la constante de Boltzmann et T la température. L'anisotropie uniaxiale peut avoir diverses origines : il peut s'agir d'une anisotropie de forme obtenue en donnant à l'élément magnétique une forme allongée (par exemple une forme d'ellipse de rapport de forme typiquement entre 1.5 et 2.5, ou de rectangle ou d'hexagone allongé). Il peut aussi s'agir d'une anisotropie d'origine magnétocristalline obtenue en induisant une texture particulière dans le plan, par exemple à l'aide de matériaux de structure hexagonale (type CoCr) dont on oriente l'axe c dans le plan. Il peut aussi s'agir d'une anisotropie liée à des contraintes obtenues par exemple en réalisant un dépôt en incidence oblique comme décrit par exemple dans l'article « Influence of déposition angle on the properties of NiO spin-valves »,

M.Cartier, S.Auffret, P.Bayle-Guillemaud, F.Ernult, F.Fettar and B.Dieny, Journal-of-Applied-Physics. vol.91, no.3; 1 Feb. 2002; p.1436-43. Dans le cas général, cette couche de stockage 303 peut être réalisée dans un alliage à base de Co, Fe, Ni contenant des additifs en particulier de B, Cr, Pt, Pd, Zr, Nb. La couche de stockage 303 peut aussi être réalisée en un matériau demi-métallique en particulier de la famille des alliages d'Heusler tels que Ni2MnAl, Ni2MnIn, Ni2MnSn, Ni2MnSb, Co2MnAl, Co2MnSi, Co2MnGa, Co2MnGe. Dans le cas d'empilement magnétorésistif à base de MgO bcc, cette couche de stockage 303 doit aussi de façon préférentielle avoir près de l'interface une structure bcc. On choisit alors un alliage à base de Co, de Fe et de Ni de structure bcc ou un alliage CoFeB amorphe que l'on recuira ensuite. Les alliages d'Heusler cités ci-dessus peuvent aussi convenir.

La couche 305 de polarisation de spin d'électrons a une aimantation hors du plan de la couche de polarisation et de direction perpendiculaire à celle de la couche de référence 301

Une telle couche 305 peut être constituée de différents types de matériaux :

- des multicouches de période (Pt/Co), (Pd/Co), (Pt/Co/Pt/Ni) telles que décrite par G.Srivinas et al (thin Solid Films 301 (1997) 211) ;

- des multicouches formées d'une alternance de couches ultrafines de Co et de Ni, par exemple de période (Co 0.2nm/Ni 0.4nm) (cf. F.den Broeder et al, Appl.Phys.Lett.61, 1468 (1992)) ;

- Certaines multicouches formées par une alternance métal de transition magnétique/oxyde comme Co-Fe/Alumine qui montrent aussi des anisotropies hors du plan importantes et résistantes en température jusqu'à 250°C. Ceci est décrit en particulier dans la demande de brevet FR2910716 ;

- des alliages ordonnés FePt ou FePd qui ont des températures d'ordre voisine de 700K et qui gardent une anisotropie hors du plan jusqu'à 250 °C ;

- des alliages CoPt ou CoPd avec des concentrations de Co entre 85% atomique et 50% atomique comme décrit dans l'article de J.Ariake et al (Journ. Magn.Magn.Mater.287 (2005) 229) ;

- des alliages CoCr de structure hexagonale avec axe c perpendiculaire au plan des couches comme ceux de composition proche de $Co_{80}Cr_{20}$ utilisés dans les média pour l'enregistrement magnétique perpendiculaire ;

- certains alliages terre-rare/métaux de transition comme TbFeCo qui présentent aussi des anisotropies hors du plan pouvant tenir en température jusqu'à des températures de 250°C. Un exemple de réalisation d'empilement magnétorésistif à aimantation hors du plan à base de tels alliages est donné dans l'article : N.Nishimura et al (Journ.Appl.Phys.91, 5246 (2002)).

De façon optionnelle, différentes améliorations peuvent être apportées à la composition de cette couche 305 de polarisation de spin d'électrons d'aimantation fixe orientée hors du plan. Celles-ci sont décrites ci-dessous :

- Il peut être avantageux de rajouter entre cette couche 305 d'aimantation fixe et le second espaceur 304 séparant cette couche 305 d'aimantation fixe de la couche 303 de stockage, une fine couche (non représentée) de matériau magnétique dont l'aimantation sera aussi hors du plan par couplage d'échange avec la couche d'aimantation fixe. Le but de cette couche magnétique additionnelle est de contrôler voire renforcer la polarisation du courant qui va être injecté dans la couche de stockage en provenance de ce polariseur additionnel. En effet, comme expliqué précédemment, il est important de faire en sorte que la contribution du transfert de spin en provenance de la couche 305 de polarisation de spin d'électrons ayant une aimantation hors du plan (polariseur perpendiculaire) soit inférieure à la contribution du transfert de spin de la couche 311 de référence. A titre d'exemple cette couche additionnelle peut être une fine couche de Co de 1 à 2 nm d'épaisseur contenant une ou deux de très fines couches d'un autre métal. Cet autre métal pourra être en Cu d'épaisseur 0.3nm si on cherche à augmenter la polarisation du courant de spin provenant de la couche 305 de polarisation de spin d'électrons, ayant une aimantation hors du plan ou au contraire en Pt ou Mn si on cherche à la diminuer.

- Il peut être aussi avantageux de remplacer la couche 305 de polarisation de spin d'électrons, ayant une aimantation fixe hors du plan, par une couche dite antiferromagnétique synthétique constituée de deux couches d'aimantation fixe orientée hors du plan et couplées antiparallèlement par une couche apte à induire un couplage antiferromagnétique entre les couches ferromagnétiques adjacentes comme par exemple une fine couche de Ruthénium d'épaisseur 0.5 à 0.9nm. On peut ainsi par exemple réaliser une couche d'aimantation fixe de composition (Co 0.25nm/Ni 0.4nm)$_6$/Ru 0.6nm/(Co 0.25nm/Ni0.4nm)$_4$. L'avantage de remplacer la couche unique d'aimantation fixe par une telle structure antiferromagnétique synthétique est de rendre l'aimantation de la couche d'aimantation fixe encore plus piégée et donc résistante aux perturbations magnétiques.

- Dans le même ordre d'idée, afin de renforcer le piégeage de la couche 305 de polarisation de spin d'électrons, ayant une aimantation fixe hors du plan, on peut coupler cette couche d'aimantation fixe simple ou antiferromagnétique synthétique à une couche antiferromagnétique par exemple en PtMn d'épaisseur typique de 12 à 20nm ou IrMn d'épaisseur typique 6 à 10nm. L'interaction d'échange entre la couche antiferromagnétique et la couche ferromagnétique adjacente a pour effet de piéger l'aimantation de la couche ferromagnétique adjacente. C'est une technique en particulier utilisée dans les vannes de spin ou empilements magnétorésistifs, technique qui fonctionne aussi avec une anisotropie perpendiculaire au plan des couches comme décrit dans l'article : « Pinned synthetic ferrimagnets with perpendicular anisotropy and tuneable exchange bias » (J.Sort, B. Rodmacq, S. Auffret, and B. Dieny, Appl. Phys. Lett. 83, 1800 (2003)).

La couche tampon 306 a pour but de promouvoir la croissance de l'ensemble de la structure et d'établir le contact électrique avec l'électrode inférieure. Il peut s'agir de couches de CuN, de Ta, de NiFeCr, de Ru, de Pt, de Cu, de multicouches (Cu/Ta). Dans ces multicouches, l'alternance des couches de cuivre et de tantale a pour but de casser la croissance des grains de cuivre pour éviter que ceux-ci ne soient trop gros. En effet, la formation de gros grains de cuivre s'accompagne souvent d'une rugosité importante de la surface de cette couche 306. L'épaisseur de cette couche 306 peut varier de 1 à quelques centaines de nm.

Comme indiqué précédemment, dans le dispositif selon l'invention, on cherche à faire en sorte que la résistance électrique de l'empilement constitué par la couche de référence 301 / le premier espaceur 302 / la couche de stockage 303 soit supérieure à la résistance électrique de l'empilement constitué par la couche de polarisation 305 / le second espaceur 304.

Pour cela, avantageusement, l'empilement constitué par la couche de référence 301 / le premier espaceur 302 / la couche de stockage 303 est un empilement magnétorésistif. Pour ce faire, le premier espaceur 302 peut être une barrière tunnel à base de MgO, AlOx, TiOx, SrTiO3, HfOx, TaOx. Cet empilement magnétorésistif sera caractérisé par un produit RA de sa résistance R par sa surface A typiquement de l'ordre de 0.5 à 300hm.micron$^2$.

Dans ce cas, le second espaceur 304 est par exemple une barrière tunnel de plus faible produit RA que celle constituant le premier espaceur 302. Elle peut être constituée du même matériau que le premier espaceur 302 (par exemple en MgO ou AlOx) mais de moindre épaisseur ou d'un matériau différent, de préférence de plus faible hauteur de barrière pour que sa résistance électrique soit moindre de celle du premier espaceur 302.

De manière alternative, ce deuxième espaceur 304 peut être une couche à chemins de courant confinés. Une telle couche est constituée d'une couche isolante percée de chemins conducteurs de diamètre typiquement de 1 à quelques nanomètres. Une telle couche est par exemple formée par oxydation d'un alliage Al99Cu1. Au cours de l'oxydation, l'aluminium s'oxyde en AlOx tandis que le cuivre qui est moins oxydable que l'aluminium coalesce en petits clusters formant les chemins conducteurs. En jouant sur la densité et la taille des chemins conducteurs, on peut ajuster le produit RA à la valeur souhaitée.

Selon l'invention, le produit RA du deuxième espaceur 304 est préférentiellement au moins 2 fois plus faible que le produit RA du premier espaceur 302 afin que la magnétorésistance tunnel de l'empilement magnétorésistif contenant le premier espaceur 302 ne soit pas trop diluée par la résistance en série du second espaceur 304.

Dans le cas particulier où le second espaceur 304 est une structure à chemin de courant confinés, les précipités métalliques formant les chemins de courant à travers la couche isolante peuvent être magnétiques par exemple en Co.

Si le premier espaceur 302 est une barrière tunnel, le second espaceur 304 peut alors être un espaceur non magnétique métallique par exemple en cuivre ou en or. Ce second espaceur 304 doit avoir la capacité de transmettre les électrons de la couche de polarisation à aimantation verticale vers la couche de stockage 303 tout en préservant la polarisation en spin des électrons. La longueur pertinente est la longueur de diffusion de spin typiquement de 20nm dans le cuivre. On veillera donc que l'épaisseur du second espaceur 304 soit bien inférieure à cette longueur. On utilisera typiquement une épaisseur de 3 à 5nm.

On notera que le premier espaceur 302 peut aussi être une couche à chemins de courant confiné comme décrit précédemment à propos du second espaceur 304. Mais dans ce cas, pour s'assurer que le second espaceur 304 a une moindre résistance que le premier espaceur 302, il faudra que le second espaceur 304 soit une couche à chemins de courant confiné présentant davantage de chemins métalliques (plus nombreux et/ou plus gros) que dans le premier espaceur 302 ou que le second espaceur 304 soit une couche non magnétique métallique apte à transmettre la polarisation en spin des électrons comme par exemple en cuivre.

Les deux espaceurs 302 et 304 peuvent enfin être deux couches métalliques, la structure couche de référence 301 /espaceur 302/ couche de stockage 303 étant alors une structure à magnétorésistance géante. Mais cette situation n'est a priori pas la plus favorable pour une application de type mémoire car la résistance totale de l'empilement sera faible par rapport à la résistance du transistor ou autre dispositif de sélection qui lui sera connecté en série.

Même si la description du présent mode de réalisation porte sur une couche de référence 301 synthétique, on notera que la couche de référence peut également être constituée d'un alliage à base de Co, Fe, Ni contenant des additifs en particulier de B, Cr, Pt, Pd, Zr, Nb. La couche de référence 301 peut aussi être réalisée en un matériau demi-métallique en particulier de la famille des alliages d'Heusler tels que Ni2MnAl, Ni2MnIn, Ni2MnSn, Ni2MnS, Co2MnAl, Co2MnSi, Co2MnGa, Co2MnGe. Dans le cas de jonctions à base de MgO bcc, cette couche de référence 301 doit aussi de façon préférentielle avoir près de l'interface une structure bcc. On choisit alors un alliage à base de Co, de Fe et de Ni de structure bcc ou un alliage CoFeB amorphe que l'on recuira ensuite.

On notera que pour augmenter la stabilité thermique de la couche de stockage 303, il peut être avantageux d'utiliser une couche de stockage synthétique. Une telle structure est illustrée en figure 10 qui représente un dispositif magnétique 400 selon un deuxième mode de réalisation de l'invention. Les différentes couches du dispositif magnétique 400 sont identiques aux couches du dispositif magnétique 300 décrit précédemment et présentent les même références et caractéristiques, la seule différence consistant à utiliser une couche 303 de stockage synthétique, c'est-à-dire composée de deux couches ferromagnétiques 409 et 411 couplées antiparallèlement à travers une couche de couplage antiparallèle 410 comme de ruthénium d'épaisseur de 0.6nm à 0.8nm. Ce faisant, on augmente le volume de la couche de stockage 310 et on rend également plus uniforme son champ interne. De ce fait, la commutation d'aimantation par transfert de spin se produit de façon plus cohérente ce qui permet d'abaisser le courant critique de retournement. Si le premier espaceur 302 est une barrière tunnel de MgO, la composition de la couche de stockage synthétique 303 pourra être du type CoFe/Ru/CoFeB. La couche 409 de CoFeB d'épaisseur typique de 1.5 à 4nm sera avantageusement en contact avec la barrière tunnel 302 de MgO pour donner une forte magnétorésistance tunnel à la structure. La couche 410 de Ru aura une épaisseur de 0.6 à 0.9nm donnant un couplage antiparallèle entre les couches 409 et 410 ferromagnétiques adjacentes.

La figure 11 représente un troisième mode de réalisation d'un dispositif magnétique 500 selon l'invention. Les différentes couches du dispositif magnétique 500 sont identiques aux couches décrites précédemment en référence au dispositif 300 et présentent les mêmes numéros de références et les mêmes caractéristiques, la seule différence consistant à supprimer le second espaceur 304. Dans le cas où le second espaceur 304 est omis, la couche 305 de polarisation de spin d'électrons, ayant une aimantation hors du plan de la couche de polarisation et de direction perpendiculaire à celle de la couche de référence 301 est directement couplée à la couche de stockage 303. Comme les aimantations de ces deux couches 303 et 305 sont essentiellement orthogonales, une paroi magnétique 501 va se former dans l'épaisseur de cette bicouche pour minimiser le coût en énergie d'échange. Il est important que l'aimantation de la couche de stockage 303 au voisinage de l'espaceur 302 soit bien parallèle ou antiparallèle à celle de la couche de référence 301 pour bénéficier de toute l'amplitude de l'effet de magnétorésistance de l'empilement couche de référence 301/espaceur 302/couche de stockage 303. Ceci signifie que l'épaisseur de la paroi 501 doit être sensiblement inférieure à l'épaisseur de la couche de stockage 303. Pour cela l'interaction d'échange entre la couche de polarisation 305 et la couche de stockage 303 doit être ajustée pour satisfaire cette condition. En effet, la largeur de paroi 501 qui va se former dans l'épaisseur va être de l'ordre de la largeur d'une paroi de Bloch c'est-à-dire en $(A/K)^{1/2}$ où A est la constante d'échange (« exchange stiffness constant » en anglais) et K est l'anisotropie. L'anisotropie est grande dans les matériaux à aimantation hors du plan (typiquement de l'ordre de quelques $10^6$ à $10^7 erg/cm^3$) et la constante d'échange peut être de l'ordre de $10^{-7}$ erg/cm conduisant à des largeurs de paroi de l'ordre de 1nm ce qui est l'ordre de grandeur recherché. Si la couche de stockage 303 fait typiquement de l'ordre de 2 à 4nm d'épaisseur, une largeur de paroi dans l'épaisseur de 1 nm est correcte.

Lorsqu'on utilise une couche de stockage 303 d'aimantation planaire, coupler directement la couche de stockage 303 avec la couche de polarisation à aimantation perpendiculaire peut présenter un avantage significatif. En effet, pour une couche d'aimantation planaire dans laquelle on injecte des électrons polarisés dans le plan (cas des électrons provenant de la couche de référence 301), la densité critique de courant pour la commutation par transfert de spin est donnée par

l'expression : : $\dfrac{\hbar}{d}\dfrac{J}{e}P = \alpha\left(\dfrac{\mu_0 M_s^2}{2} + 2K\right)$. Dans cette expression, J est la densité de courant, P la polarisation du courant, $\mu_0$ la permittivité magnétique ($4\pi 10^{-7}$SI), e la charge de l'électron, $M_s$ l'aimantation spontanée de la couche de stockage, d son épaisseur, K son anisotropie uniaxiale, $\alpha$ l'amortissement de Gilbert. Dans l'expression du courant critique de commutation, il apparait que le terme dominant est le terme $\alpha\dfrac{\mu_0 M_s^2}{2}$ .

Ce terme traduit la difficulté qu'a l'aimantation de la couche de stockage 303 à sortir hors du plan lors de son mouvement de précession accompagnant la commutation de l'aimantation. Si maintenant l'aimantation de la couche de stockage 303 est directement couplée à la couche de polarisation perpendiculaire comme dans le cas du dispositif magnétique 500, il est clair que ceci va faciliter son aptitude à sortir hors du plan. En effet la couche de stockage 303 à aimantation planaire va avoir tendance à être tirée hors du plan par l'interaction d'échange avec la couche de polarisation 305. On peut typiquement réduire l'énergie de champ démagnétisant

$\dfrac{\mu_0 M_s^2}{2}$ d'un facteur 2 voire plus grâce à cette interaction, ce qui permet de réduire d'autant la densité de courant critique de commutation.

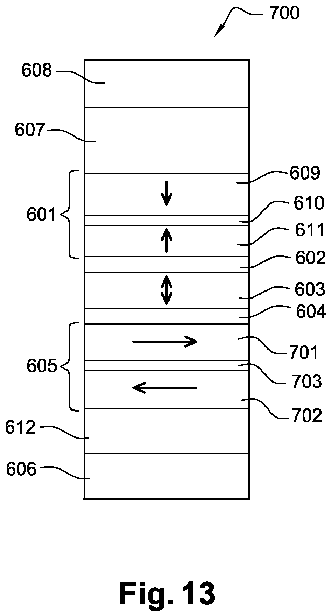

Comme nous l'avons déjà évoqué plus haut, au lieu d'utiliser des couches à aimantation planaire pour la couche de stockage et la couche de référence, et une couche à aimantation hors du plan pour la couche de polarisation additionnelle, il est possible de tourner toutes ces aimantations de 90° c'est-à-dire d'utiliser des couches à aimantation hors du plan pour la couche de stockage et la couche de référence et une couche à aimantation planaire pour la couche de polarisation additionnelle. Cette rotation de 90° de l'aimantation est décrite dans ce qui suit en référence aux deux modes de réalisation des figures 12 et 13. Dans chacune de ces figures, la couche de référence a une aimantation de direction fixe située perpendiculairement au plan de la couche de référence ; la couche de stockage a une aimantation de direction variable possédant deux positions d'équilibre sensiblement suivant l'axe défini par la direction d'aimantation fixe de la couche de référence; la couche de polarisation de spin d'électrons a une aimantation perpendiculaire à celle de la couche de référence et située dans le plan de la couche de polarisation.

La figure 12 représente un quatrième mode de réalisation d'un dispositif magnétique 600 selon l'invention.

Le dispositif magnétique 600 comporte un empilement formé par:

- une couche de protection 608 ;
- une première couche de piégeage antiferromagnétique 607 ;
- une couche magnétique de référence 601 de direction d'aimantation fixe (ici perpendiculaire au plan de la couche de référence) ;
- un premier espaceur non magnétique 602 ;
- une couche magnétique de stockage 603 de direction d'aimantation réorientable suivant deux états d'orientation sensiblement opposées (deux positions d'équilibre sensiblement suivant l'axe défini par la direction d'aimantation fixe de la couche de référence 601) ;
- un second espaceur 604 ;
- une couche 605 de polarisation de spin d'électrons, ayant une aimantation dans le plan de la couche de polarisation et de direction perpendiculaire à celle de la couche de référence 601 ;
- une seconde couche de piégeage antiferromagnétique 612
- une couche tampon 606.

La couche tampon 606 a pour but de promouvoir la croissance de l'ensemble de la structure et d'établir le contact électrique avec l'électrode inférieure. Il peut s'agir de couches de CuN, de Ta, de NiFeCr, de Ru, de Pt, de Cu, de multicouches (Cu/Ta). Dans ces multicouches, l'alternance des couches de cuivre et de tantale a pour but de casser la croissance des grains de cuivre pour éviter que ceux-ci ne soient trop gros. En effet, la formation de gros grains de cuivre s'accompagne souvent d'une rugosité importante de la surface de cette couche tampon 606. L'épaisseur de cette couche tampon 606 peut varier de 1 à quelques centaines de nm.

La couche de référence 601 est ici une couche antiferromagnétique synthétique comprenant deux couches ferromagnétiques 611 et 609 couplées antiparallèlement à travers une fine couche 610 de couplage antiparallèle, par exemple en ruthénium d'épaisseur 0.6nm à 0.8nm. La couche de référence 601 est par exemple une couche antiferromagnétique synthétique de composition (Co 0.25nm/Ni 0.4nm)$_6$/Ru 0.6nm/(Co 0.25nm/Ni0.4nm)$_8$. L'avantage d'utiliser une couche de référence synthétique est de réduire le champ magnétostatique exercé par cette couche sur l'aimantation de la couche de stockage. Il est important que ce champ rayonné soit faible pour ne pas di-symétriser de façon excessive les deux états d'aimantation de la couche de stockage 603 (état « vers le haut » et état « vers le bas »). La couche de référence synthétique 601 est elle-même piégée par interaction avec une première couche antiferromagnétique de piégeage 607 par exemple d'IrMn d'épaisseur 7nm. La première couche antiferromagnétique de piégeage 607 peut être supprimée, en particulier si le champ coercitif de la couche synthétique de référence 601 est suffisamment élevé, typiquement supérieur ou égal à 2 kOe (1 Oe = 1000 / $4\pi$ A/m $\approx$ 79,5775 A/m).

La couche de piégeage antiferromagnétique 607 est recouverte par la couche de protection 608 servant à la protéger de l'oxydation lors de l'exposition à l'air pendant le procédé de fabrication et servant également de contact électrique avec l'électrode supérieure de l'empilement.

La couche de stockage 603 possède dans ce mode de réalisation une aimantation hors du plan. Cette couche de stockage peut être réalisée via différents types de matériaux tels que :

- des multicouches de période (Pt/Co), (Pd/Co) ou (Pt/Co/Pt/Ni) (cf. article de G.Srivinas et al, thin Solid Films 301 (1997) 211) ;
- des multicouches formées d'une alternance de couches ultrafines de Co et de Ni, par exemple de période (Co 0.2nm/Ni 0.4nm) (cf. article de F.den Broeder et al, Appl.Phys.Lett.61, 1468 (1992)) ;
- certaines multicouches métal de transition magnétique/oxyde comme CoFe/Alumine montrent aussi des anisotropies hors du plan importantes et résistantes en température jusqu'à 250°C. Ceci est décrit en particulier dans la demande de brevet FR2910716 ;
- des alliages ordonnés FePt ou FePd ;
- des alliages CoPt ou CoPd avec des concentrations de Co entre 85% atomique et 50% atomique comme décrit dans l'article de J.Ariake et al (Journ.Magn.Magn.Mater.287 (2005) 229) ;
- des alliages CoCr de structure hexagonale avec axe c perpendiculaire au plan des couches comme ceux de composition proche de $Co_{80}Cr_{20}$ utilisés dans les média pour l'enregistrement magnétique perpendiculaire ;
- certains alliages terre-rare/métaux de transition comme TbFeCo présentent aussi des anisotropies hors du plan. Un exemple de réalisation d'empilement magnétorésistif à aimantation hors du plan à base de tels alliages est donné dans l'article de N.Nishimura et al (Journ.Appl.Phys.91, 5246 (2002)).

Même si la description du présent mode de réalisation porte sur une couche de référence 601 synthétique, on notera que la couche de référence peut également être constituée des mêmes matériaux que ceux cités ci-dessus pour la couche de stockage 603. De même que pour la couche de stockage 603, afin de maximiser l'amplitude de magnétorésistance de l'empilement couche de stockage 603 / premier espaceur 602 /couche de référence 601, il pourra être avantageux d'introduire à l'interface entre le premier espaceur 602 et la couche de référence 601 une couche additionnelle de matériau magnétique dont l'aimantation sera tirée hors du plan par interaction d'échange avec le reste de la couche de stockage 603. Dans le cas où le premier espaceur 602 est une barrière tunnel à base de MgO, cette couche magnétique additionnelle sera avantageusement en CoFeB.

Avantageusement, l'interface de la couche de stockage 603 en contact avec le second espaceur 604 est magnétique de sorte que le transfert de spin dû à la couche 605 de polarisation à aimantation planaire puisse s'exercer sur l'aimantation de la couche de stockage 603. Dans le cas de multicouches (Co/Pt) ou (Co/Pd), l'empilement au dessus du second espaceur 604 doit commencer par une couche magnétique par exemple en Co. De même, l'interface avec le premier espaceur 602 doit être magnétique ce qui veut dire que l'empilement de la couche de stockage 603 doit se terminer par une couche magnétique par exemple en Co, CoFe ou CoFeB (avantageusement en CoFeB si le premier espaceur 602 est une barrière tunnel de MgO).

Comme indiqué précédemment en référence aux figures 5, 9, 10 et 11, dans le dispositif selon l'invention, on cherche à faire en sorte que la résistance électrique de l'empilement constitué par la couche de référence 601 / le premier espaceur 602 / la couche de stockage 603 soit supérieure à la résistance électrique de l'empilement constitué par la couche de polarisation 605 / le second espaceur 604.

Pour cela, avantageusement, l'empilement constitué par la couche de référence 601 / le premier espaceur 602 / la couche de stockage 603 est un empilement magnétorésistif. Pour ce faire, le premier espaceur 602 peut être une barrière tunnel à base de MgO, AlOx, TiOx, SrTiO3, HfOx, TaOx. Cet empilement magnétorésistif sera caractérisé par un produit RA de sa résistance R par sa surface A.

Dans ce cas, le second espaceur 604 est par exemple une barrière tunnel de plus faible produit RA que celle constituant le premier espaceur 602. Elle peut être constituée du même matériau que le premier espaceur 602 (par exemple en MgO ou AlOx) mais de moindre épaisseur ou d'un matériau différent, de préférence de plus faible hauteur de barrière pour que sa résistance électrique soit moindre de celle du premier espaceur 602.

De manière alternative, ce deuxième espaceur 604 peut être une couche à chemins de courant confinés. Une telle couche est constituée d'une couche isolante percée de chemins conducteurs de diamètre typiquement de 1 à quelques nanomètres. En jouant sur la densité et la taille des chemins conducteurs, on peut ajuster le produit RA à la valeur souhaitée.

Selon l'invention, le produit RA du deuxième espaceur 604 est préférentiellement au moins 2 fois plus faible que le produit RA du premier espaceur 602 afin que la magnétorésistance tunnel de l'empilement magnétorésistif contenant le premier espaceur 602 ne soit pas trop diluée par la résistance en série du second espaceur 604.

Dans le cas particulier où le second espaceur 604 est une structure à chemins de courant confinés, les précipités métalliques formant les chemins de courant à travers la couche isolante peuvent être magnétiques par exemple en Co.

Si le premier espaceur 602 est une barrière tunnel, le second espaceur 604 peut alors être un espaceur non magnétique métallique par exemple en cuivre ou en or. Ce second espaceur 604 doit avoir la capacité de transmettre les électrons de la couche de polarisation à aimantation planaire vers la couche de stockage 603 tout en préservant la polarisation en spin des électrons. La longueur pertinente est la longueur de diffusion de spin typiquement de 20nm dans le cuivre. On veillera donc que l'épaisseur du second espaceur 604 soit bien inférieure à cette longueur.

On notera que le premier espaceur 602 peut aussi être une couche à chemins de courant confiné comme décrit précédemment à propos du second espaceur 604. Mais dans ce cas, pour s'assurer que le second espaceur 604 a une moindre résistance que le premier espaceur 602, il faudra que le second espaceur 604 soit une couche à chemins de courant confiné présentant davantage de chemins métalliques (plus nombreux et/ou plus gros) que dans le premier espaceur 602 ou que le second espaceur 604 soit une couche non magnétique métallique apte à transmettre la polarisation en spin des électrons comme par exemple en cuivre.

La couche 605 de polarisation de spin d'électrons, ayant une aimantation dans le plan de la couche de polarisation peut être un alliage à base de Co, Fe, Ni contenant des additifs en particulier de B, Cr, Pt, Pd, Zr, Nb. L'épaisseur typique de cette couche est de l'ordre de 2 à 5nm. Cette couche 605 peut aussi être constituée d'une multicouche par exemple de Co contenant de fines insertions de Cu d'épaisseur typique entre 0.2 et 0.4nm ou de Ni. La couche 605 de polarisation peut aussi être réalisée en un matériau demi-métallique en particulier de la famille des alliages d'Heusler tels que Ni2MnAl, Ni2MnIn, Ni2MnSn, Ni2MnSb, Co2MnAl, Co2MnSi, Co2MnGa, Co2MnGe.

La figure 13 représente un cinquième mode de réalisation d'un dispositif magnétique 700 selon l'invention. Les différentes couches du dispositif magnétique 700 sont identiques aux couches décrites précédemment en référence au dispositif 700 et présentent les mêmes numéros de références et les mêmes caractéristiques, la seule différence consistant à utiliser une couche de polarisation 605 synthétique. Cette couche 605 de polarisation à aimantation planaire est donc une couche antiferromagnétique synthétique c'est-à-dire formé de deux couches magnétiques 701 et 702 orientées antiparallèlement l'une à l'autre à travers une fine couche 703 de ruthénium d'épaisseur 0.6 à 0.9nm. Les deux couches magnétiques 701 et 702 peuvent être composées des mêmes matériaux ou de matériaux différents. Cette couche 605 antiferromagnétique synthétique est elle-même être piégée par interaction avec la sous couche 612 antiferromagnétique de piégeage par exemple en PtMn 20nm ou IrMn 7nm déposée sur la couche tampon 606.

On notera enfin qu'il peut être aussi avantageux de remplacer la couche de stockage 605 à aimantation commutable hors du plan, telle que représentée en figures 12 et 13, par une couche antiferromagnétique synthétique constituée de deux couches d'aimantation fixe orientée hors du plan et couplées antiparallèlement par une couche apte à induire un couplage antiferromagnétique entre couches ferromagnétiques adjacentes comme par exemple une fine couche de ruthénium d'épaisseur 0.5 à 0.9nm. On peut ainsi par exemple réaliser une couche d'aimantation commutable de composition (Co 0.25nm/Ni 0.4nm)$_6$/Ru 0.6nm/(Co 0.25nm/Ni0.4nm)$_4$. L'avantage de remplacer la couche unique d'aimantation commutable par une telle structure antiferromagnétique synthétique est d'en augmenter la stabilité thermique en augmentant son volume.

## Revendications

1. Dispositif magnétique (200, 300, 400, 500, 600, 700) comportant :

   - une première couche magnétique (201, 301, 601), dite couche de référence, ayant une aimantation de direction fixe située soit dans le plan de la couche de référence (201, 301) soit perpendiculairement au plan de la couche de référence (601) ;
   - une seconde couche magnétique (203, 303, 603), dite couche de stockage, ayant une aimantation de direction variable ;
   - une couche non magnétique (202, 302, 602), dite espaceur, séparant ladite couche de référence (201, 301, 601) et ladite couche de stockage (203, 303, 603) ;
   - une troisième couche magnétique (205, 305, 604), dite couche de polarisation de spin d'électrons, ayant une aimantation perpendiculaire à celle de ladite couche de référence (201, 301, 601) et située hors du plan de la couche de polarisation (205, 305) si l'aimantation de la couche de référence (201, 301) est orientée dans le plan de la couche de référence (201, 301) ou dans le plan de la couche de polarisation (605) si l'aimantation de la couche de référence (601) est orientée perpendiculairement au plan de la couche de référence (601) ;
   - des moyens (206, 207) pour faire circuler dans les couches, et perpendiculairement à celles-ci, un courant d'électrons ;

ledit dispositif (200, 300, 400, 500, 600, 700) étant **caractérisé en ce que** ladite aimantation de direction variable possède deux positions d'équilibre sensiblement suivant l'axe défini par ladite direction d'aimantation fixe de ladite couche de référence (201, 301, 601), le coefficient de transfert de spin entre ladite couche de référence (201, 301, 601) et ladite couche de stockage (203, 303, 603) étant supérieur au coefficient de transfert de spin entre ladite couche de polarisation de spin (205, 305, 605) et ladite couche de stockage (203, 303, 603) de sorte qu'en présence d'un courant d'électrons :

   - le transfert de spin entre ladite couche de polarisation de spin (205, 305, 605) et ladite couche de stockage (203, 303, 603) écarte la direction d'aimantation de ladite couche de stockage (203, 303, 603) d'une première position d'équilibre parallèle ou antiparallèle à la direction d'aimantation de ladite couche de référence (201, 301, 601) puis,
   - le transfert de spin entre ladite couche de référence (201, 301, 601) et ladite couche de stockage (203, 303, 603) entraîne en fonction de la direction du courant d'électrons :

      ∘ soit la commutation de la direction d'aimantation de ladite couche de stockage (203, 303, 603) vers une deuxième position d'équilibre correspondant à une direction d'aimantation de ladite couche de stockage (203, 303, 603) opposée à la direction d'aimantation de ladite couche de stockage (203, 303, 603) dans ladite première position d'équilibre si la direction du courant d'électrons est dans un premier sens ;
      ∘ soit le retour de la direction d'aimantation de ladite couche de stockage (203, 303, 603) vers sa direction d'aimantation dans ladite première position d'équilibre si la direction du courant d'électrons est dans un sens opposé au premier sens.

2. Dispositif (200, 300, 400, 500, 600, 700) selon la revendication 1 **caractérisé en ce que** ladite couche de stockage (203, 303, 603) présente une anisotropie uniaxiale avec un axe facile d'aimantation sensiblement parallèle à la direction d'aimantation de ladite couche de référence (201, 301, 601).

3. Dispositif (200, 300, 400, 500, 600, 700) selon la revendication 2 **caractérisé en ce que** ladite couche de stockage (203, 303, 603) présente une forme allongée telle qu'une forme elliptique.

4. Dispositif (200, 300, 400, 600, 700) selon l'une des revendications 1 à 3 **caractérisé en ce qu'**il comporte une couche, dite second espaceur (204, 304, 604), séparant ladite couche de stockage (203, 303, 603) et ladite couche de polarisation de spin d'électrons (205, 305, 605).

5. Dispositif (200, 300, 400, 600, 700) selon la revendication 4 **caractérisé en ce que** la résistance électrique de l'empilement formé par ladite couche de référence (201, 301, 601), ledit premier espaceur (202, 302, 602) et ladite couche de stockage (203, 303, 603) est supérieure à la résistance électrique de l'empilement formé par ledit second espaceur (204, 304, 604) et ladite couche de polarisation de spin d'électrons (205, 305, 605).

6. Dispositif (200, 300, 400, 600, 700) selon l'une des revendications 4 ou 5 **caractérisé en ce que** le produit de la résistance par la surface dudit premier espaceur (202, 302, 602) est supérieur au produit de la résistance par la surface dudit second espaceur (204, 304, 604).

7. Dispositif (200, 300, 400, 600, 700) selon l'une des revendications 4 à 6 **caractérisé en ce que** ledit premier espaceur (202, 302, 602) est une barrière tunnel et ledit second espaceur (204, 304, 604) est choisi parmi les éléments suivants :

 - une barrière tunnel ;
 - une barrière à chemins de courant confinés ;
 - une couche métallique non magnétique.

8. Dispositif (200, 300, 400, 600, 700) selon l'une des revendications 4 à 6 **caractérisé en ce que** ledit premier (202, 302, 602) espaceur est une barrière à chemins de courant confinés et ledit second espaceur (204, 304, 604) est choisi parmi les éléments suivants :

 - une barrière à chemins de courant confinés ;
 - une couche métallique non magnétique.

9. Dispositif (200, 300, 400, 600, 700) selon la revendication 8 **caractérisé en ce que** ledit second espaceur (204, 304, 604) est une barrière à chemins de courant confinés présentant davantage de chemins métalliques et/ou des chemins magnétiques de diamètres plus grands que dans le premier espaceur (202, 302, 602)

10. Dispositif (200, 300, 400, 600, 700) selon l'une des revendications 4 à 6 **caractérisé en ce que** lesdits premier (202, 302, 602) et second (204, 304, 604) espaceurs sont des couches métalliques non magnétiques.

11. Dispositif (500) selon l'une des revendications 1 à 3 **caractérisé en ce que** ladite couche de polarisation de spin d'électrons (305) est directement couplée à ladite couche de stockage (303).

12. Dispositif (200, 300, 400, 500) selon l'une des revendications 1 à 11 **caractérisé en ce que** ladite couche de référence (201, 301) a une aimantation de direction fixe située dans le plan de la couche de référence (201, 301) et ladite couche de polarisation de spin d'électrons (205, 305) a une aimantation perpendiculaire à celle de ladite couche de référence (201, 301) et située hors du plan de la couche de polarisation (205, 305).

13. Dispositif (600, 700) selon l'une des revendications 1 à 11 **caractérisé en ce que** ladite couche de référence (601) a une aimantation de direction fixe perpendiculairement au plan de la couche de référence (601) et ladite couche de polarisation de spin d'électrons (605) a une aimantation perpendiculaire à celle de ladite couche de référence (601) et située dans le plan de la couche de polarisation (605).

14. Dispositif (300, 400, 500, 600, 700) selon l'une des revendications 1 à 11 **caractérisé en ce qu'**au moins l'une desdites couches de référence (301, 601), de stockage ou de polarisation de spin d'électrons est une couche antiferromagnétique synthétique formée de deux couches (309, 311, 609, 611) d'aimantation fixe orientée hors du plan et couplées antiparallèlement par une couche (310, 610) apte à induire un couplage antiferromagnétique entre les couches ferromagnétiques.

15. Dispositif (300, 400, 500, 600, 700) selon l'une des revendications 1 à 11 ou selon la revendication 14 **caractérisé en ce qu'**au moins l'une desdites couches de référence (301, 601) ou de polarisation de spin d'électrons présente une aimantation piégée par interaction avec une couche antiferromagnétique (307, 607) de piégeage.

16. Procédé d'écriture/lecture d'information dans un dispositif selon l'une des revendications précédentes **caractérisé en ce que** l'écriture d'information consiste à faire circuler à travers le dispositif perpendiculairement au plan des couches un courant d'électrons, la commutation de la direction d'aimantation de ladite couche de stockage vers la deuxième position d'équilibre se faisant par l'injection d'un courant d'électrons dans un premier sens et la commutation de la direction d'aimantation de ladite couche de stockage vers la première position d'équilibre se faisant par l'injection d'un courant d'électrons dans un deuxième sens opposé au dit premier sens du courant.

17. Procédé d'écriture/lecture selon la revendication précédente **caractérisé en ce que** la lecture d'information consiste à faire circuler à travers le dispositif perpendiculairement au plan des couches un courant d'électrons et à mesurer la résistance dudit dispositif, l'intensité du courant de lecture étant inférieure à l'intensité du courant d'écriture.

## Patentansprüche

1. Magnetische Vorrichtung 200, 300, 400, 500, 600, 700), umfassend:

> - eine erste magnetische Schicht (201, 301, 601), genannt Referenzschicht, die eine feste Richtungsmagnetisierung aufweist, welche entweder in der Ebene der Referenzschicht (201; 301) angeordnet ist oder lotrecht zur Ebene der Referenzschicht (601) ist;
> - eine zweite magnetische Schicht (203, 303, 603, genannt Speicherschicht, die eine variable Richtungsmagnetisierung aufweist;
> - eine nicht magnetische Schicht (202, 302, 602), genannt Abstandshalter, die die genannte Referenzschicht (201, 301, 601) und die genannte Speicherschicht (203, 303, 603) trennt;
> - eine dritte magnetische Schicht (205, 305, 604), genannt Elektronenspin-Polarisationsschicht, die eine Magnetisierung aufweist, welche zu der der genannten Referenzschicht (201, 301, 610) lotrecht ist und außerhalb der Ebene der Polarisationsschicht (205 305) angeordnet ist, wenn die Magnetisierung der Referenzschicht (201, 301) in der Ebene der Referenzschicht (201, 301) oder in der Ebene der Polarisationsschicht (605) ausgerichtet ist, wenn die Magnetisierung der Referenzschicht (601) lotrecht zur Ebene der Referenzschicht (601) ausgerichtet ist;
> - Mittel (206, 207) zum Zirkulieren eines Elektronenstroms in den Schichten und lotrecht zu diesen;
> wobei die genannte Vorrichtung (200, 300, 400, 500, 600, 700) **dadurch gekennzeichnet ist, dass** die genannte variable Richtungsmagnetisierung zwei Gleichgewichtspositionen deutlich gemäß der Achse besitzt, die von der genannten festen Magnetisierungsrichtung der genannten Referenzschicht (201, 301, 601) definiert ist, wobei der Spin-Übertragungskoeffizient zwischen der genannten Referenzschicht (201, 301, 601) und der genannten Speicherschicht (203, 303, 603) größer ist als der Spin-Übertragungskoeffizient zwischen der genannten Spin-Polarisationsschicht (205, 305, 605) und der genannten Speicherschicht (203, 3030, 603) derart, dass bei Vorhandensein eines Elektronenstroms:

- die Spinübertragung zwischen der genannten Spin-Polarisationsschicht (205, 305, 605) und der genannten Speicherschicht (203, 303, 603) die Magnetisierungsrichtung der genannten Speicherschicht (203, 303, 603) einer ersten Gleichgewichtsposition abspreizt, die zu der Magnetisierungsrichtung der genannten Referenzschicht (201, 301, 601) parallel oder antiparallel ist, dann
- die Spin-Übertragung zwischen der genannten Referenzschicht (201, 301, 601) und der genannten Speicherschicht (203, 303, 603) in Abhängigkeit von der Richtung des Elektronenstroms antreibt:

> ◦ entweder die Umschaltung der Magnetisierungsrichtung der genannten Speicherschicht (203, 3030, 603) in eine zweite Gleichgewichtsposition, die einer Magnetisierungsrichtung der genannten Speicherschicht (203, 303, 603) entspricht, die der Magnetisierungsrichtung der genannten Speicherschicht (203, 303, 603) in der genannten ersten Gleichgewichtsposition entgegengesetzt ist, wenn die Richtung des Elektronenstroms in einer ersten Richtung ist;
> ◦ oder die Rückkehr der Magnetisierungsrichtung der genannten Speicherschicht (203, 303, 603) in ihre Magnetisierungsrichtung in der genannten ersten Gleichgewichtsposition, wenn die Richtung des Elektronenstroms in einer zur ersten Richtung entgegengesetzten Richtung ist.

2. Vorrichtung (200, 300, 400, 500, 600, 700) gemäß Anspruch 1, **dadurch gekennzeichnet, dass** die genannte Speicherschicht (203, 303, 603) eine einachsige Anisotropie mit einer leichten Magnetisierungsachse aufweist, die deutlich parallel zur Magnetisierungsrichtung der genannten Referenzschicht (201, 301, 601) ist.

3. Vorrichtung (200, 300, 400, 500, 600, 700) gemäß Anspruch 2, **dadurch gekennzeichnet, dass** die genannte Speicherschicht (203, 303, 603) eine längliche Form, wie z. B. eine elliptische Form, aufweist.

4. Vorrichtung (200, 300, 400, 600, 700) gemäß einem der Ansprüche 1 bis 3, **dadurch gekennzeichnet, dass** sie eine Schicht, genannt Abstandshalter (204, 304, 604), umfasst, die die genannte Speicherschicht (203, 303, 603) und die genannte Elektronenspin-Polarisationsschicht (205, 305, 605) trennt.

5. Vorrichtung (200, 300, 400, 600, 700) gemäß Anspruch 4, **dadurch gekennzeichnet, dass** der elektrische Widerstand der Stapelung, die durch die genannte Referenzschicht (201, 301, 601), den genannten ersten Abstandshalter (202, 302, 602) und die genannte Speicherschicht (203, 303, 603) geformt ist, größer ist als der elektrische Widerstand der Stapelung, die durch den genannten zweiten Abstandshalter (204, 304, 604) und die genannte Elektronenspin-Polarisationsschicht (205, 305, 605) geformt ist.

6. Vorrichtung (200, 300, 400, 600, 700) gemäß einem der Ansprüche 4 oder 5, **dadurch gekennzeichnet, dass** das Produkt des Widerstandes mit der Oberfläche des genannten ersten Abstandshalters (202, 302, 602) größer ist als das Produkt des Widerstandes mit der Oberfläche des genannten zweiten Abstandshalters (204, 304, 604).

7. Vorrichtung (200, 300, 400, 600, 700) gemäß einem der Ansprüche 4 bis 6, **dadurch gekennzeichnet, dass** der genannte erste Abstandshalter (202, 302, 602) eine Tunnelbarriere ist und der genannte zweite Abstandshalter (204, 304, 6043) aus den folgenden Elementen ausgewählt ist:

   - einer Tunnelbarriere;
   - einer Barriere mit eingeschlossenen Stromwegen;
   - einer nicht magnetischen, metallischen Schicht.

8. Vorrichtung (200, 300, 400, 600, 700) gemäß einem der Ansprüche 4 bis 6 **dadurch gekennzeichnet, dass** der genannte erste (202, 302, 602) Abstandshalter eine Barriere mit eingeschlossenen Stromwegen ist und der genannte zweite Abstandshalter (204, 304, 604) aus den folgenden Elementen ausgewählt ist:

   - einer Barriere mit eingeschlossenen Stromwegen;
   - einer nicht magnetischen, metallischen Schicht.

9. Vorrichtung (200, 300, 400, 600, 700) gemäß Anspruch 8, **dadurch gekennzeichnet, dass** der genannte zweite Abstandshalter (204, 304, 604) eine Barriere mit eingeschlossenen Stromwegen ist, die mehr metallische Wege und / oder magnetische Wege mit größeren Durchmessern als in dem ersten Abstandshalter (202, 302, 602) aufweisen.

10. Vorrichtung (200, 300, 400, 600, 700) gemäß einem der Ansprüche 4 bis 6, **dadurch gekennzeichnet, dass** die genannten ersten (202, 302, 602) und zweiten (204, 304, 604) Abstandshalter nicht magnetische, metallische Schichten sind.

11. Vorrichtung (500) gemäß einem der Ansprüche 1 bis 3, **dadurch gekennzeichnet, dass** die genannte Elektronenspin-Polarisationsschicht (305) direkt an die genannte Speicherschicht (303) gekoppelt ist.

12. Vorrichtung (200, 300, 400, 500) gemäß einem der Ansprüche 1 bis 11, **dadurch gekennzeichnet, dass** die genannte Referenzschicht (201, 301) eine feste Richtungsmagnetisierung in der Ebene der Referenzschicht (201, 301) aufweist und die genannte Elektronenspin-Polarisationsschicht (205, 305) eine Magnetisierungsrichtung aufweist, die lotrecht zu der der Referenzschicht (2301, 301) ist und außerhalb der Polarisationsschicht (205, 305) angeordnet ist.

13. Vorrichtung (600, 700) gemäß einem der Ansprüche 1 bis 11, **dadurch gekennzeichnet, dass** die genannte Referenzschicht (601) eine feste Richtungsmagnetisierung aufweist, die lotrecht zur Ebene der Referenzschicht (601) ist und die genannte Elektronenspin-Polarisationsschicht (605) eine Magnetisierung aufweist, die lotrecht zu der der genannten Referenzschicht (601) ist und in der Ebene der Polarisationsschicht (605) angeordnet ist.

14. Vorrichtung (300, 400, 600, 700) gemäß einem der Ansprüche 1 bis 11, **dadurch gekennzeichnet, dass** wenigstens eine der genannten Referenz-, (301, 601), Speicher- oder Elektronenspin-Polarisationsschichten eine synthetische, antiferromagnetische Schicht ist, die aus zwei festen Magnetisierungsschichten (309, 311, 609, 611) geformt ist, die außerhalb der Ebene ausgerichtet und antiparallel durch eine Schicht (301, 610) gekoppelt sind, die geeignet ist, eine antiferromagnetische Kopplung zwischen den ferromagnetischen Schichten zu induzieren.

15. Vorrichtung (300, 400, 600, 700) gemäß einem der Ansprüche 1 bis 11 oder gemäß Anspruch 14, **dadurch gekennzeichnet, dass** wenigstens eine der genannten Referenz- (301, 601) oder Elektronenspin-Polarisationsschichten eine Magnetisierung aufweist, die per Zusammenwirken mit einer antiferromagnetischen Einfang-Schicht (307, 607) eingefangen ist.

16. Informationslese- / Informationsschreibverfahren in einer Vorrichtung gemäß einem der voranstehenden Ansprüche, **dadurch gekennzeichnet, dass** die Schreibinformation darin besteht, einen Elektronenstrom durch die Vorrichtung, die lotrecht zur Ebene der Schichten ist, zirkulieren zu lassen, wobei das Umschalten der Magnetisierungsrichtung der genannten Speicherschicht zur zweiten Gleichgewichtsposition per Einschießen eines Elektronenstroms in einer ersten Richtung und das Umschalten der Magnetisierungsrichtung der genannten Speicherschicht zur ersten Gleichgewichtsposition per Einschießen eines Elektronenstroms in einer zweiten Richtung erfolgt, die der genannten ersten Richtung des Stroms entgegengesetzt ist.

17. Lese- / Schreibverfahren gemäß dem voranstehenden Anspruch, **dadurch gekennzeichnet, dass** das Lesen von Informationen darin besteht, einen Elektronenstrom durch die Vorrichtung lotrecht zur Ebene der Schichten zirkulieren zu lassen und den Widerstand der genannten Vorrichtung zu messen, wobei die Intensität des Lesestroms geringer ist als die Intensität des Schreibstroms.

**Claims**

1. Magnetic device (200, 300, 400, 500, 600, 700) comprising:

    - a first magnetic layer (201, 301, 601), referred to as a reference layer, with a fixed magnetisation direction located either in the plane of the reference layer (201, 301) or perpendicular to the plane of the reference layer (601);
    - a second magnetic layer (203, 303, 603), referred to as a storage layer, with a variable magnetisation direction;
    - a non-magnetic layer (202, 302, 602), known as a spacer, separating said reference layer (201, 301, 601) and said storage layer (203, 303, 603);
    - a third magnetic layer (205, 305, 605), referred to as a spin polarising layer with a direction perpendicular to that of said reference layer (201, 301, 601) and located out of the plane of the spin polarising layer (205, 305) if the magnetisation of the reference layer (201, 301) is directed in the plane of the reference layer (201, 301) or in the plane of the spin polarising layer (605) if the magnetisation of the reference layer (601) is directed perpendicular to the plane of the reference layer (601);
    - means (206, 207) for passing a current of electrons through and perpendicular to the layers;

    said device (200, 300, 400, 500, 600, 700) being **characterised in that** said variable magnetisation direction has two positions of equilibrium substantially following the axis defined by said fixed magnetisation direction of said reference layer (201, 301, 601), the spin transfer coefficient between said reference layer (201, 301, 601) and said storage layer (203, 303, 603) being higher than the spin transfer coefficient between said spin polarising layer (205, 305, 605) and said storage layer (203, 303, 603) in such a way that, when in the presence of a current of electrons:

    - the spin transfer between said spin polarising layer (205, 305, 605) and said storage layer (203, 303, 603) moves the magnetisation direction of said storage layer (203, 303, 603) away from a first position of equilibrium parallel or anti-parallel to the magnetisation direction of said reference layer (201, 301, 601), then,
    - the spin transfer between said reference layer (201, 301, 601) and said storage layer (203, 303, 603) causes, according to the direction of the current of electrons:

        ○ either the switching of the magnetisation direction of said storage layer (203, 303, 603) towards a second position of equilibrium corresponding to a magnetisation direction of said storage layer (203, 303, 603) opposite to the magnetisation direction of said storage layer (203, 303, 603) in said first position of equilibrium if the direction of the current of electrons is in a first direction;
        ○ or the reversal of the magnetisation direction of said storage layer (203, 303, 603) towards its magnetisation direction in said first position of equilibrium if the direction of the current of electrons is in the direction opposite to the first direction.

2. Device (200, 300, 400, 500, 600, 700) according to claim 1, **characterised in that** said storage layer (203, 303, 603) has a uni-axial anisotropy with an easy axis of magnetisation substantially parallel to the magnetisation direction of said reference layer (201, 301, 601).

3. Device (200, 300, 400, 500, 600, 700) according to claim 2, **characterised in that** said storage layer (203, 303, 603) has an extended shape such as an elliptical shape.

4. Device (200, 300, 400, 600, 700) according to one of claims 1 to 3, **characterised in that** it comprises a layer, referred to as a second spacer (204, 304, 604) separating said storage layer (203, 303, 603) and said spin polarising layer (205, 305, 605).

5. Device (200, 300, 400, 600, 700) according to claim 4, **characterised in that** the electrical resistance of the stack formed from said reference layer (201, 301, 601), said first spacer (202, 302, 602) and said storage layer (203, 303, 603) is higher than the electrical resistance of the stack formed from said second spacer (204, 304, 604) and said spin polarising layer (205, 305, 605).

6. Device (200, 300, 400, 600, 700) according to one of claims 4 or 5, **characterised in that** the product of the resistance multiplied by the surface area of said first spacer (202, 302, 602) is higher than the product of the resistance multiplied by the surface area of said second spacer (204, 304, 604).

7. Device (200, 300, 400, 600, 700) according to one of claims 4 to 6, **characterised in that** said first spacer (202, 302, 602) is a tunnel barrier and said second spacer (204, 304, 604) is chosen from among the following elements:

   - a tunnel barrier;
   - a confined current paths barrier;
   - a non-magnetic metallic layer.

8. Device (200, 300, 400, 600, 700) according to one of claims 4 to 6, **characterised in that** said first spacer (202, 302, 602) is a confined current paths barrier and said second spacer (204, 304, 604) is chosen from among the following elements:

   - a confined current paths barrier;
   - a non-magnetic metallic layer.

9. Device (200, 300, 400, 600, 700) according to claim 8, **characterised in that** said second spacer (204, 304, 604) is a confined current paths barrier with additional metallic paths and/or magnetic paths with larger diameters than in the first spacer (202, 302, 602).

10. Device (200, 300, 400, 600, 700) according to one of claims 4 to 6, **characterised in that** said first (202, 302, 602) and second (204, 304, 604) spacers are non-magnetic, metallic layers.

11. Device (500) according to one of claims 1 to 3, **characterised in that** said spin polarising layer (305) is directly coupled with said storage layer (303).

12. Device (200, 300, 400, 500) according to one of claims 1 to 11, **characterised in that** said reference layer (201, 301) has a fixed magnetisation direction located in the plane of the reference layer (201, 301) and said spin polarising layer (205, 305) has a magnetisation perpendicular to that of said reference layer (201, 301) and located out of the plane of the polarisation layer (205, 305).

13. Device (600, 700) according to one of claims 1 to 11, **characterised in that** said reference layer (601) has a fixed magnetisation direction perpendicular to the plane of the reference layer (601) and said spin polarising layer (605) has a magnetisation direction perpendicular to that of said reference layer (601) and located in the plane of the spin polarising layer (605).

14. Device (300, 400, 500, 600, 700) according to one of claims 1 to 11, **characterised in that** at least one of said reference layers (301, 601), storage layers or spin polarising layers is a synthetic antiferromagnetic layer formed from two layers (309, 311, 609, 611) of fixed magnetisation directed outside of the plane and coupled in an anti-parallel direction with a layer (310, 610) capable of inducing an antiferromagnetic coupling between the ferromagnetic layers.

15. Device (300, 400, 500, 600, 700) according to one of claims 1 to 11 or according to claim 14, **characterised in that** at least one of said reference layers (301, 601) or spin polarising layers has a magnetisation anchored via interaction with an antiferromagnetic anchoring layer (307, 607).

16. Method of writing/reading information in a device according to one of the previous claims, **characterised in that** the writing of information consists in passing a current of electrons through the device, perpendicular to the plane of the layers, the switching of the magnetisation direction of said storage layer towards the second position of equilibrium being performed by injecting a current of electrons in a first direction and the switching of the magnetisation direction of said storage layer towards the first position of equilibrium being performed by injecting a current of electrons in a second direction opposite to said first direction of the current.

17. Method of writing/reading according to the previous claim, **characterised in that** the reading of information consists in passing a current of electrons through the device, perpendicular to the plane of the layers and in measuring the resistance of said device, the intensity of the reading current being lower than the intensity of the writing current.

**Fig. 1**

**Fig. 2**

**Fig. 3**

**Fig. 4**

**Fig. 5**

**Fig. 6**

J>0 (électrons de couche de stockage vers couche de polarisation.)

My

Etat initial P

0

Etat initial AP

temps

**Fig. 7A**

J<0 (électrons de couche de polarisation vers couche de stockage.)

My

Etat initial P

Etat initial AP

temps

**Fig. 7B**

FIGURE 8

**Fig. 9**

**Fig. 10**

**Fig. 11**

**Fig. 12**

**Fig. 13**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 6545906 B
- FR 2832542
- FR 2817998
- US 20090015958 A1
- FR 2910716

### Littérature non-brevet citée dans la description

- **JC.SLONCZEWSKI ; L.BERGER.** *Journ.magn.Magn.Mater.,* 1996, vol. 159 (L1
- *Phys.Rev.B.,* 1996, vol. 54, 9353
- **J.KATINE et al.** *Phys.Rev.Lett.,* 2000, vol. 84, 3149
- *Phys.Rev.Lett.,* 2000, vol. 84, 3149
- *Appl.Phys.Lett.,* 2004, vol. 84, 3118
- **SUN.** *Phys.Rev.B.,* 2000, vol. 62, 570
- **Y.HUAI et al.** *Appl.Phys.Lett.,* 2005, vol. 87, 222510
- *Journ.Appl.Phys.,* 2003, vol. 93, 7693
- **T.DEVOLDER et al.** *Phys.Rev.Lett.,* 2008, vol. 100, 057206
- **Y.HUAI et al.** *Applied Physics Letters,* 2004, vol. 84, 3118
- **M.CARTIER ; S.AUFFRET ; P.BAYLE-GUILLEMAUD ; F.ERNULT ; F.FETTAR ; B.DIENY.** Influence of déposition angle on the properties of NiO spin-valves. *Journal-of-Applied-Physics,* 01 Février 2002, vol. 91 (3), 1436-43
- **G.SRIVINAS et al.** *thin Solid Films,* 1997, vol. 301, 211
- **F.DEN BROEDER et al.** *Appl.Phys.Lett.,* 1992, vol. 61, 1468
- **J.ARIAKE et al.** *Journ. Magn.Magn.Mater.,* 2005, vol. 287, 229
- **N.NISHIMURA et al.** *Journ.Appl.Phys.,* 2002, vol. 91, 5246
- **J.SORT ; B. RODMACQ ; S. AUFFRET ; B. DIENY.** Pinned synthetic ferrimagnets with perpendicular anisotropy and tuneable exchange bias. *Appl. Phys. Lett.,* 2003, vol. 83, 1800
- **J.ARIAKE et al.** *Journ.Magn.Magn.Mater.,* 2005, vol. 287, 229